(19) Europäisches Patentamt
European Patent Office
Office européen des brevets

(11) **EP 1 258 026 B1**

(12) **EUROPÄISCHE PATENTSCHRIFT**

(45) Veröffentlichungstag und Bekanntmachung des Hinweises auf die Patenterteilung:
**28.12.2016 Patentblatt 2016/52**

(21) Anmeldenummer: **01900068.6**

(22) Anmeldetag: **12.01.2001**

(51) Int Cl.:
***H01J 37/34*** *(2006.01)*

(86) Internationale Anmeldenummer:
**PCT/CH2001/000021**

(87) Internationale Veröffentlichungsnummer:
**WO 2001/063643 (30.08.2001 Gazette 2001/35)**

(54) **VERFAHREN ZUR STEUERUNG DER PLASMADICHTE ODER DEREN VERTEILUNG IN EINER MAGNETRONSPUTTERQUELLE UND MAGNETRONSPUTTERQUELLE**

METHOD FOR CONTROLLING PLASMA DENSITY OR THE DISTRIBUTION THEREOF IN A MAGNETRON SPUTTER SOURCE AND MAGNETRON SPUTTER SOURCE

PROCEDE DE REGULATION DE LA DENSITE D'UN PLASMA OU DE SA DISTRIBUTION DANS UNE SOURCE DE PULVERISATION AU MAGNETRON ET SOURCE DE PULVERISATION AU MAGNETRON

(84) Benannte Vertragsstaaten:
**AT BE CH CY DE DK ES FI FR GB GR IE IT LI LU MC NL PT SE TR**

(30) Priorität: **23.02.2000 CH 3512000**

(43) Veröffentlichungstag der Anmeldung:
**20.11.2002 Patentblatt 2002/47**

(73) Patentinhaber: **Evatec AG**
**9477 Trübbach (CH)**

(72) Erfinder: **KRASSNITZER, Siegfried**
**A-6800 Feldkirch (AT)**

(74) Vertreter: **Troesch Scheidegger Werner AG**
**Schwäntenmos 14**
**8126 Zumikon (CH)**

(56) Entgegenhaltungen:
**EP-A- 0 674 337      EP-A- 0 762 471**
**DE-A- 4 102 102      DE-A- 19 749 690**
**US-A- 5 130 005**

EP 1 258 026 B1

## Beschreibung

Die vorliegende Erfindung betrifft ein Verfahren zur Steuerung der Plasmadichte oder deren Verteilung über der Targetanordnung einer Magnetronquelle ein Verfahren zur Fertigung beschichteter Werkstücke sowie Magnetronquellen.

## Definition

Wir verstehen unter einer Magnetronquelle eine Sputterquelle, woran die Entladung DC, AC oder, gemischt, AC und DC oder mit gepulstem DC betrieben wird, wobei AC bis in den Hf-Bereich zu verstehen ist. Die Quelle wird üblicherweise in Vakuum mit einem Arbeitsgas, wie z.B. Argon, bei Drücken von einigen mbar bis $10^{-3}$ mbar betrieben. Für reaktive Prozesse können in bekannter Weise reaktive Zusatzgase beigemischt werden.

Über der Sputterfläche der Targetanordnung wird an einer Magnetronquelle ein tunnelförmiges Magnetfeld erzeugt, welches, in Aufsicht auf die zu zerstäubende Fläche, die Sputterfläche, eine geschlossene Schleife bildet. In Targetanordnungs-Querschnittsrichtung betrachtet, tritt mindestens ein Teil des Magnetfeldes aus der Sputterfläche aus und in diese wieder ein, Tunnelbogen-förmig. Die Zerstäubungsfläche, auch Targetfläche genannt, bildet die eine Elektrode der Plasmaentladungsstrecke, die Kathode, da für den Zerstäubungsvorgang positive Ionen auf die Targetfläche beschleunigt werden müssen. Diese Elektrode kann auch unterteilt werden und ihre Teile können individuell elektrisch gespiesen werden.

Im Bereich der Schleife des tunnelförmigen Magnetfeldes herrscht somit ein elektrisches Feld, welches im wesentlichen zum Tunnelfeld gewinkelt ist. Es ergibt sich eine tunnelförmige Elektronenfalle und ein ausgeprägter Elektronenstrom, der im wesentlichen im und entlang der Schleife des tunnelförmigen

Magnetfeldes umläuft. Dieser Elektronenstrom bewirkt im Bereich des erwähnten, schleifenförmig umlaufenden, tunnelförmigen Magnetfeldes eine ausgeprägte Erhöhung der Plasmadichte verglichen mit der Plasmadichte weiter ausserhalb der erwähnten Magnetfeldschleife.

Damit ergibt sich entlang des in der Fachwelt als "race track" bezeichneten, umlaufenden Elektronenstromes eine wesentlich erhöhte Sputterrate, was zu einem sich mehr und mehr ausbildenden Erosionsgraben in der Sputterfläche, d.h. an der Basis des tunnelförmig umlaufenden Magnetfeldes, führt.

Dieser sich zunehmend ausbildende Erosionsgraben hat, nebst grundsätzlich den grossen Vorteilen von Magnetronquellen, negative Einflüsse auf

- Beschichtungshomogenität am beschichteten Substrat,

- Ausnützungsgrad des Targetmaterials.

Um diese Nachteile mindestens teilweise aufzufangen, ist es bekannt, z.B. aus DE 197 49 690 A1, das ganze oder grössere Teile des tunnelförmig in einer Schleife umlaufenden Magnetfeldes bezüglich der Targetanordnung bzw. dessen Sputterfläche zu bewegen, insbesondere zyklisch zu bewegen. Dadurch wird eine zeitliche Verteilung der "race track"-Elektronenstromwirkung entlang der bestrichenen Sputterflächenbereiche erreicht. Aus US5130005 A ist ein weiteres Beispiel einer Magnetronsputterquelle bekannt.

Berücksichtigt man, dass üblicherweise das geschleift tunnelförmig umlaufende Magnetfeld durch eine Anordnung starker Permanentmagnete unterhalb der Targetanordnung realisiert wird, so ist erkenntlich, dass einerseits eine bestehende Permanentmagnetanordnung, die, für die Verschiebung des erwähnten Magnetfeldes, unterhalb der Targetanordnung mechanisch bewegt wird, nur mit relativ grossem Aufwand geometrisch geändert werden kann, um unterschiedliche Erosionsprofil-Verteilungen zu realisieren, und dass im Sputterbetrieb eine Veränderung dieser Verteilung bzw. der Geometrie der Permanentmagnetanordnung kaum möglich ist.

Die vorliegende Erfindung geht von der Aufgabe aus, die Plasmadichte bzw. Plasmadichteverteilung über der Sputterfläche der Targetanordnung anders oder zusätzlich steuern zu können und dabei diese Steuerung auch während des Beschichtungsprozesses vornehmen zu können.

Dies wird beim Verfahren eingangs genannter Art dadurch erreicht, dass man lokal, d.h. entlang eines begrenzten Teilabschnittes der umlaufenden Schleife des tunnelförmigen Magnetfeldes, dieses Magnetfeld steuernd verändert. In einem zweiten Lösungsansatz wird die gestellte Aufgabe gelöst dadurch, dass man dem tunnelförmigen Magnetfeld grundsätzlich ein steuerndes Magnetfeld überlagert. Unter dem ersten Ansatz wird das entsprechende Feld also lokal verändert, unter dem zweiten ein zusätzliches Magnetfeld dem tunnelförmigen überlagert.

Aus der US-A-5 512 150 ist eine Magnetronsputterquelle bekannt, bei der das tunnelförmige Magnetfeld über der Targetanordnung bezüglich seiner radialen Ausdehnung verändert werden kann. Hierzu wird unterhalb der Targetanordnung, topfartig, ein Elektromagnet angeordnet, der durch Stromrichtungsumkehr umgepolt wird. Dieser Elektromagnet erzeugt selber das tunnelförmige Magnetfeld: Er muss deshalb äusserst stark sein, was zu einer grossen voluminösen Spule mit entsprechender Wärmeentwicklung führt.

Die Nachteile dieses bekannten Vorgehens werden erfindungsgemäss unter beiden Ansätzen mittels eines Verfahrens nach Anspruch 1 und mittels einer Vorrichtung nach Anspruch 15 umgangen.

Erfindungsgemäss wurde erkannt, dass durch nur lokale Änderung von tunnelförmigem Magnetfeld die Elektronenfalle mehr oder weniger gestört wird, was, entsprechend dem jeweils gewählten Arbeitspunkt und der angesteuerten Veränderung, zu einer Zu- oder Abnahme der Plasmadichte entlang der gesamten Elektronenfalle führt.

Bezüglich des mittleren Umfanges der Elektronenfalle, in Aufsicht, wird dabei der erwähnte lokale Eingriff in einem Umfangsbereich von höchstens 1/3 Umfangslänge, bevorzugt auf einem Bereich von höchstens 1/4 Umfangslänge realisiert, vorzugsweise in einem Bereich, der wesentlich kürzer ist.

Bezogen auf den mittleren Polabstand d der Polbereiche, aus denen das tunnelförmige Magnetfeld aus der Sputterfläche aus und daran wieder eintritt, ergibt sich eine bevorzugte Länge $l_B$ des "lokalen" Bereiches, an dem eingegriffen wird bevorzugt zu:

$$0 < l_B \leq 4\ d$$

bevorzugt

$$0 < l_B \leq 2\ d$$

insbesondere von

$$0 < l_B \leq d.$$

Wenn im weiteren von "lokal" gesprochen wird, so bevorzugt mit den eben angesprochenen geometrischen Bezügen zu mittlerer Schleifenumfangslänge und/oder zu mittlerem Polabstand, insbesondere gemittelt im betrachteten Eingriffsbereich.

Auch wenn, unter dem zweiten Ansatz der vorliegenden Erfindung, nicht mehr zwingend lokal, dem tunnelförmigen Magnetfeld ein steuerndes Magnetfeld überlagert wird, derart, dass das Mass, mit welchem die Anode in das resultierende Magnetfeld eingreift, steuernd verändert wird, wird steuernd auf die Wirkung der Elektronenfalle und den umlaufenden Elektronenstrom Einfluss genommen und damit auf die Plasmadichte und Sputterrate entlang der ganzen umlaufenden Schleife.

In einer bevorzugten Ausführungsform wird auch gemäss dem ersterwähnten Ansatz der vorliegenden Erfindung das tunnelförmige Magnetfeld lokal steuernd so verändert, dass das erwähnte Mass verändert wird.

Weil gemäss dem ersten Ansatz der Erfindung nur lokal auf Magnetfeld eingegriffen wird, ist es durchaus möglich, das tunnelförmige Magnetfeld auch durch steuernden Eingriff auf deren jeweilige Erzeuger selber, also ohne Überlagerung, zu verändern. Wird nach dem zweiten Ansatz der Erfindung dem umlaufenden tunnelförmigen Magnetfeld ein steuerndes Magnetfeld überlagert, so erfolgt dies in einer bevorzugten Ausführungsform entlang mindestens eines Grossteils der Schleife des tunnelförmigen Magnetfeldes. Das überlagerte Feld wird bevorzugterweise im wesentlichen senkrecht zur Targetsputterfläche und, in einer weiteren bevorzugten Ausführungsform, im wesentliche homogen, d.h. mit örtlich konstanter Feldstärkenverteilung, angelegt. Es ist aber durchaus möglich, dieses überlagerte Feld auch lokal unterschiedlich stark auszubilden und/oder unterschiedlich stark steuernd zu variieren.

Die beiden Ansätze können durchaus kombiniert realisiert werden.

Die Veränderung des umlaufenden Elektronenstromes kann, ersatzbildmässig, als Veränderung der Plasmaimpedanz der betroffenen Entladungszone bzw. Schleife betrachtet werden.

Sind, im Quellenbetrieb, an einer Targetanordnung mehr als eine Elektronenfalle mit der jeweiligen Magnetfeldschleife vorgesehen, so kann dies als eine Parallelschaltung der je den Tunnelfeldschleifen zugeordneter Plasmaimpedanzen betrachtet werden. Daraus ergibt sich nun ein weiterer höchst vorteilhafter Effekt der vorliegenden Erfindung: Wenn die erfindungsgemässe Steuerung - nach einem oder nach beiden erwähnten Aspekten - an mindestens einer der Elektronenfallen eingesetzt wird, wirkt sich dies als Steuerung einer Impedanz einer Impedanz-Parallelschaltung aus, woraus eine Steuerung der Stromverteilung auf die Parallelimpedanzen resultiert. Es erfolgt somit eine Steuerung und entsprechende Umverteilung der Plasmadichten, Sputterleistungen und Sputterraten an den vorgesehenen Schleifen bzw. Elektronenfallen. Dabei kann bei den betrachteten mindestens zwei Elektronenfallen die eine innerhalb der andern liegen, oder sie können nebeneinander liegen.

Im weiteren wird in einer weitaus bevorzugten Ausführungsform die mindestens eine Elektronenfalle mit ihrer Schleife des tunnelförmigen Magnetfeldes im Betrieb über der Targetanordnung bzw. deren Sputterfläche bewegt, vorzugsweise gesteuert und vorzugsweise zyklisch, sei dies z.B. pendelnd oder in einer kontinuierlichen Umlauf-Bewegung.

Insbesondere unter dem ersten Aspekt - Applikation einer lokalen steuernden Änderung - wird mit der Veränderung die Form der Schleife der Elektronenfalle gesteuert verändert, bevorzugt zyklisch oder nach einem anderen zeitlichen Programm, oder es wird die Elektronenfalle - dies auch unter dem zweiten Aspekt - gesteuert, vorzugsweise zyklisch oder nach einem anderen zeitlichen Programm, geschwächt bzw. verstärkt, bis hin zu deren Ab- und Aufschalten.

Die erfindungsgemässe Steuerung kann in diskreten Schritten erfolgen oder kontinuierlich. Werden zwei der erwähnten Steuergrössen, Magnetfeld und elektrisches Feld, gleichzeitig eingesetzt, kann diskrete Steuerung und kontinuierliche gegebenenfalls kombiniert werden.

In bevorzugter Ausführungsform, insbesondere gemäss dem ersten Lösungsansatz der vorliegenden Erfindung, wird für gesteuerte Veränderung des Magnetfeldes eine steuerbare Elektromagnetanordnung und/oder eine mechanisch gesteuert bewegliche Permanentmagnetanordnung und/oder ferromagnetische Shuntanordnung eingesetzt, gegebenenfalls in Kombination.

Betrachtet man weiter den Fall einer oder mehrerer im Betrieb über der Sputterfläche verschobener bzw. bewegter Elektronenfalle, so ergibt sich eine bevorzugte Ausführungsform dadurch, dass die steuernde Elektromagnet- und/oder Permanentmagnetanordnung und/oder Shuntanordnung zusammen mit der oder den Elektronenfallen bewegt wird bzw. werden. Notwendige Stromzuführungen können z.B. über Schleifringe realisiert werden, dies insbesondere unter Berücksichtigung der geringen, notwendigen Ansteuer-Leistungen.

Insbesondere unter dem zweiten Ansatz der vorliegenden Erfindung, bei dem nämlich nicht zwingend nur lokal, sondern bevorzugterweise über wesentliche Bereiche des schleifenförmig umlaufenden Tunnelmagnetfeldes, diesem ein Steuer-Magnetfeld überlagert wird, wird das überlagerte Steuermagnetfeld vorzugsweise quellenfest vorgesehen.

Die Erfindung betrifft weiter ein Herstellungsverfahren für beschichtete Werkstücke nach dem Wortlaut von Anspruch 14.

Mit einer erfindungsgemässen Sputterbeschichtungskammer nach Anspruch 24 bzw. einer Vakuumbehandlungsanlage nach Anspruch 25 lassen sich, aufgrund des erfindungsgemässen Vorgehens, höchst vorteilhafte Vakuumbehandlungen durchführen, immer unter Einschluss des erfindungsgemässen Magnetronsputterns, wobei die Substrate mit optimierter Schichtdickenverteilung und/oder Verteilung der Schichtzusammensetzung resultieren, deren Realisation bislang nur mit wesentlich aufwendigeren Vorgehensweisen möglich war.

Es soll an dieser Stelle betont werden, dass sich die erfindungsgemässen Verfahren, Herstellungsverfahren, Magnetronsputterquellen, Vakuumbehandlungskammern und die Vakuumbehandlungsanlagen selbstverständlich auch im Rahmen reaktiver Beschichtungsverfahren einsetzen lassen, bei denen das von der Targetanordnung abgesputterte Material mit einem plasmaaktivierten Reaktivgas eine Verbindung eingehen, die sich als Beschichtungsmaterial auf dem oder den jeweiligen Substraten niederlegt.

Die Erfindung wird anschliessend beispielsweise anhand von Figuren erläutert. Es zeigen:

Fig. 1  schematisch, einen Ausschnitt eines Targets einer Magnetronquelle mit darüber in einer geschlossenen Schleife erzeugtem, tunnelförmigem Magnetfeld einer Elektronenfalle, einen ersten Ansatz erfindungsgemässen Vorgehens zeigend;

Fig. 2  schematisch, eine erste Ausführungsform einer an der Elektronenfalle gemäss Fig. 1 realisierten erfindungsgemässen Magnetfeldansteuerung;

Fig. 3  in Darstellung analog zu Fig. 2, eine zweite, meist bevorzugte Ausführungsform;

Fig. 4  eine dritte Ausführungsform in zu den Fig. 2 und 3 analoger Darstellung unter Einsatz eines Shuntes;

Fig. 5  in Darstellung analog zu den Fig. 2 - 4, eine Ansteuerung mit gesteuerter Veränderung der elektrischen Feldverhältnisse;

Fig. 6  in einer Darstellung analog zu Fig. 1, die Realisation der vorliegenden Erfindung nach einem zweiten Ansatz, mit Überlagerung eines Steuer-Magnetfeldes;

Fig. 7  schematisch, in Aufsicht, eine erfindungsgemässe Magnetronsputterquelle mit teilweise weggeschnittener Targetanordnung und Realisation des erfindungsgemässen Vorgehens im wesentlichen nach Fig. 3, dabei in einer bevorzugten Ausführungsform;

Fig. 8  schematisch die Realisationsform gemäss Fig. 7 an einem Rechtecktarget;

Fig. 9  in schematischer Seitenansicht, eine bevorzugte Realisationsform der erfindungsgemässen Ansteuerung gemäss Fig. 7;

Fig. 10  in Seitenansicht, die bevorzugte Ausführungsform nach Fig. 9;

Fig. 11(a), (b)  an einer im wesentlichen gemäss Fig. 7 aufgebauten Magnetronquelle, die Auswirkungen der erfindungsgemässen Ansteuerung auf die Plasmadichte bzw. deren Verteilung;

Fig. 12  in Darstellung analog zu Fig. 11, ein weiteres Beispiel der Auswirkungen der erfindungsgemässen Ansteuerung auf die Plasmadichteverteilung;

Fig. 13 bis 16  als Anschauungsbeispiele, mit den Vorgehen nach den Fig. 11 bzw. 12 realisierbare Schichtdickenverteilungen an Substraten;

Fig. 17  ausgehend von einer Realisation einer erfindungsgemässen Sputterquelle nach Fig. 3, schematisch eine weitere Realisationsmöglichkeit;

Fig. 18  ausgehend vom Prinzip einer Sputterquelle gemäss Fig. 5, eine Realisationsform in schematischer Aufsicht;

Fig. 19  schematisch in Aufsicht, eine erfindungsgemässe Magnetronsputterquelle, bei der das erfindungsgemässe Vorgehen unter seinem zweiten Ansatz gemäss Fig. 6 realisiert ist;

Fig. 20          in Aufsicht, die Magnetkranzanordnung einer erfindungsgemässen Magnetronsputterquelle weiterer Ausführungsform;

Fig. 21 (a), (b)   die Auswirkungen der an der Quelle nach Fig. 20 vorgesehenen erfindungsgemässen Steuerung auf die Plasmadichteverteilung;

Fig. 22          in Aufsicht und in Darstellung analog zu Fig. 11 bzw. 13, eine weitere Ausführungsform einer erfindungsgemäss ansteuerbaren, erfindungsgemässen Magnetronquelle, und

Fig. 23 (a), (b)   die Auswirkungen der erfindungsgemässen Ansteuerung auf die Plasmadichteverteilung an einer erfindungsgemässen Magnetronquelle, im wesentlichen aufgebaut gemäss Fig. 6 bzw. 19.

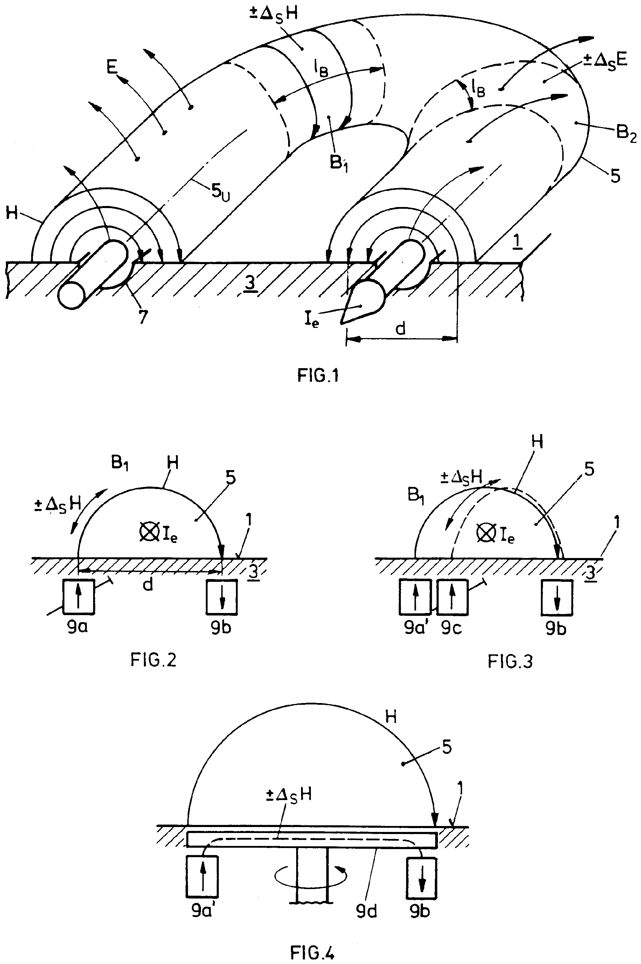

In Fig. 1 sind schematisch und ohne Anspruch auf wissenschaftliche Exaktheit die Verhältnisse bei Realisation der Erfindung unter ihrem ersten Ansatz dargestellt. Über der Sputterfläche 1 einer Targetanordnung 3 wird in hier nicht weiter dargestellter Art und Weise, beispielsweise mit zwei Kränzen unter der Targetanordnung 3 angeordneter Permanentmagnete, das in einer geschlossenen Schleife 5 über der Sputterfläche 1 umlaufende tunnelförmige Magnetfeld H erzeugt.

In der Zone der Schleife 5 ist weiter ein das Magnetfeld H gewinkelt kreuzendes elektrisches Feld E aufgebaut, zwischen der Targetanordnung als Kathode und einer in bekannter Art und Weise vorgesehenen (nicht dargestellten) Entladungsanode. Aufgrund dieser Feldverhältnisse bildet sich eine effiziente Elektronenfalle aus, welche einen namhaften Elektronenstrom $I_e$ bewirkt, der im wesentlichen in der Magnetfeldschleife 5 umläuft und wesentlich grösser ist als der Plasmaentladungsstrom abseits des erwähnten tunnelförmigen Feldes. Aufgrund der an diesem Ort herrschenden hohen Elektronenstromdichte ergibt sich dort eine hohe Plasmadichte, eine erhöhte lokale Sputterrate und schliesslich ein Sputtererosionsgraben 7 in der Sputterfläche 1.

Unter dem erwähnten ersten Ansatz der vorliegenden Erfindung wird nun lokal, im Bereich $B_1$, entlang der Magnetfeldschleife 5 das dort vorherrschende tunnelförmige Magnetfeld H steuernd gestört bzw. verändert, $\pm\Delta_S H$. Die erwähnte Steuergrösse kann in getrennten Bereichen $B_1$ und $B_2$ oder im Bereich $B_{12}$ eingesetzt werden. Durch diese lokalen Eingriffe wird die Wirkung der Elektronenfalle über die ganze umlaufende Schleife drastisch gestört bzw. verändert.

Wenn gemäss Fig. 1 die gesamte mittlere Umfangslänge U der Schleife 5 betrachtet wird, wovon bei $5_U$ ein Teil in Fig. 1 eingetragen ist, und die im wesentlichen der Umfangslänge des Grabens 7 entspricht, so kann für die Länge $I_B$ der Bereiche $B_1$ bzw. $B_2$ ausgesagt werden, dass $I_B \leq 1/3$ U, vorzugsweise $I_B \leq 1/4$ U ist, bevorzugt wesentlich kleiner.

Bezogen auf den mittleren Polabstand d, der im wesentlichen dem Abstand der das tunnelförmige Magnetfeld H bildenden Magnetpole (s. Fig. 2) entspricht, gilt für $I_B$ vorzugsweise:

$$0 < l_B \leq 4\ d$$

bevorzugt

$$0 < l_B \leq 2\ d$$

insbesondere

$$0 < l_B \leq d.$$

In Weiterbetrachtung des erwähnten ersten Erfindungsansatzes sind in den Fig. 2, 3 und 4 schematisch Möglichkeiten dargestellt, das Magnetfeld H lokal im Bereich $B_1$ gemäss Fig. 1 steuernd zu ändern.

In Fig. 2 ist, vereinfachend dargestellt, ein Teilquerschnitt durch die Anordnung von Fig. 1 mit dem schleifenförmig umlaufenden Tunnelmagnetfeld H dargestellt. Es sind dieselben Bezugszeichen wie in Fig. 1 verwendet. Das Magnetfeld H wird hier erzeugt durch unterhalb der Sputterfläche 1 im oder unterhalb der Targetanordnung 3 vorgesehene, im wesentlichen wie die Magnetfeldschleife 5 umlaufende Kränze von Magneten 9a bzw. 9b. Während das Magnetfeld H durch Permanentmagnete erzeugt wird, ist gemäss Fig. 2 im dargestellten Bereich $B_1$ mindestens eines der felderzeugenden Magnete, 9a, gesteuert veränderbar ausgebildet. Dies kann durch lokales Vorsehen einer Elektromagnetanordnung realisiert werden oder durch eine lokale Anordnung mit gesteuert beweglichem Permanentmagnet, dessen Bewegung z.B. erlaubt, seine Wirkungsstärke oder Polarisationsrichtung mit Bezug auf die neben dem Bereich $B_1$ angeordneten "Haupt"-Magnete des betrachteten Kranzes zu ändern. Auf eine weitere Möglichkeit wird im Zusammenhang mit Fig. 4 eingegangen.

Somit kann gemäss Fig. 2 die erfindungsgemäss nach Fig. 1 eingesetzte Magnetfeldänderung $\pm\Delta_S H$ lokal durch die H-felderzeugende Magnetanordnung selber realisiert sein.

In Fig. 3 ist in zu Fig. 2 analoger Darstellungsweise eine weitere Realisationsform der Erfindung unter ihrem ersten Ansatz dargestellt, bei der wiederum lokal im Bereich $B_1$ (Fig. 1) das Magnetfeld H gesteuert verändert wird. Wie sich durch Quervergleich mit Fig. 2 ohne weiteres ergibt, werden hier die das schleifenförmig umlaufende Tunnelmagnetfeld H erzeugenden Magnetanordnungen 9a' und 9b bei der erfindungsgemässen Steuerung nicht verändert, sondern es ist lokal eine weitere Magnetanordnung, beispielsweise ein ansteuerbarer Magnet 9c, vorgesehen, welcher ein dem Magnetfeld H überlagertes Feld erzeugt. Das Überlagerungsresultat des unveränderten Feldes H mit dem überlagerten Steuermagnetfeld führt wiederum zur erfindungsgemäss im Bereich $B_1$ genutzten Feldänderung $\pm \Delta_S H$. Die Magnetanordnung 9c kann wiederum durch eine Elektromagnetanordnung und/oder durch eine mechanisch gesteuert bewegte Permanentmagnetanordnung realisiert sein, wobei aber im Vergleich mit der Ausführungsform nach Fig. 2 diese Magnetanordnungen jedenfalls nur das Steuerfeld erzeugen müssen und somit wesentlich schwächer ausgebildet sein können als gemäss Fig. 2.

In Fig. 4 ist, in zu den Fig. 2 und 3 analoger Darstellung, eine weitere Variante dargestellt, das tunnelförmige Feld H erfindungsgemäss zu ändern. Hierzu werden die Magnete 9a' bzw. 9b gemäss Fig. 3, die gemeinsam das Feld H erzeugen, gesteuert mehr oder weniger magnetisch geshuntet. Zum Beispiel und gemäss Fig. 4 wird ein balkenförmiges, ferromagnetisches Shunt-Element mechanisch gesteuert getrieben zur Wirkung gebracht bzw. ausser Wirkung gebracht. Dazu wird z.B. das balkenförmige ferromagnetische Shuntelement 9d von der dargestellten Voll-Shuntposition in die dazu querstehende "Shunt-aus"-Position gedreht.

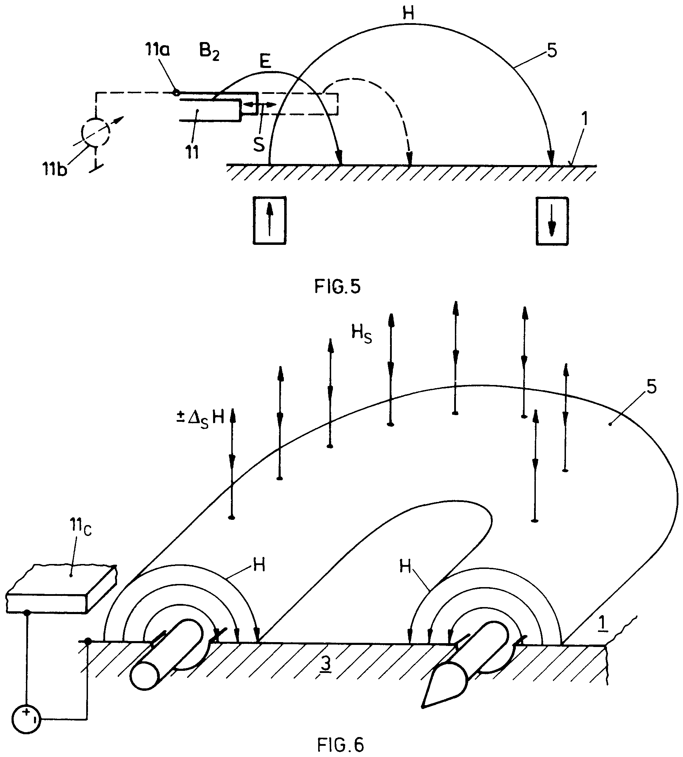

Wir wenden uns nun der in der folgenden Figur 5 schematisch dargestellten Realisationsmöglichkeit zu, weiterhin der Erfindung unter ihrem ersten Ansatz folgend, aber bei erfindungsgemäss gesteuert und lokal verändertem elektrischem Feld E.

Gemäss Fig. 5, einer Darstellung analog zu den Figuren 2 - 4 jedoch nicht Teil der Erfindung, wird das tunnelförmige H-Feld nicht verändert. Statt dessen wird, in einem Bereich $B_2$ gemäss Fig. 1, vorzugsweise bezüglich U bzw. d wie oben angegeben bemessen, das E-Feld an der kathodischen Sputterfläche 1 lokal geändert. Dazu wird die Anode 1 aus nicht ferromagnetischem Material im Bereich $B_2$ wie mit S dargestellt in das tunnelförmige Magnetfeld H eingeschoben bzw. rückgeholt. Hierzu ist im Bereich $B_2$ die Anode 11 als motorisch gesteuerte Teilanode 11a ausgebildet. Zusätzlich zur mechanischen Beweglichkeit oder an deren statt, kann der Anodenteil 11a auf gesteuert veränderbares Potential gelegt werden, wie dies mit der einstellbaren Quelle 11b dargestellt ist.

Wird ein anodischer Teil, wie der mechanisch bewegte Teil 11a, so relativ zum Magnetfeld H zur Wirkung gebracht, dass er in unterschiedlichem gesteuerten Mass in dieses Magnetfeld eingreift, so wird - äusserst sensibel - die Elektronenfalle drastisch gestört, der Schleifenstrom fliesst über diesen Anodenteil ab. Dies erfolgt auch dann, wenn durch gesteuerte Änderung des Magnetfeldes H (Figuren 2 - 4) das Magnetfeld H einer Anoden-Teil-nahen Elektronenfalle gegen diese hinverformt wird, oder wenn dies (Fig. 5) durch gesteuerte Wirkung eines anodischen Teils erfolgt oder auch, bei Vorgehen nach dem zweiten Ansatz, wenn die anodennahe Elektronenfalle gesteuert ganz oder in Teilabschnitt von der Entladungsanode oder einem anodischen ) Teil angeschnitten wird.

Die Ausnützung dieses Effektes eignet sich insbesondere für die Ein-/Abschaltung einer Elektronenfalle. Umgekehrt betrachtet, eignen sich somit insbesondere Anodenteil-nahe Elektronenfallen, um erfindungsgemäss ein-/ausschaltend angesteuert zu werden. Anodenteil-fernere Elektronenfallen eignen sich hingegen eher für eine erfindungsgemässe Ansteuerung zu ihrer stetigen oder geschalteten Formänderung durch lokale Magnetfeldänderung.

In Fig. 6 ist, in einer Darstellung analog zu derjenigen von Fig. 1, das erfindungsgemässe Vorgehen, dem zweiten Ansatz folgend, dargestellt. Es sind für die bereits in Fig. 1 dargestellten und beschriebenen Grössen dieselben Bezugszeichen eingesetzt. Demnach wird nicht mehr lokal, sondern über wesentliche Bereiche, ja den ganzen Bereich des schleifenförmig umlaufenden, tunnelförmigen Magnetfeldes H, somit bevorzugterweise entlang der gesamten Schleife 5, diesem Magnetfeld H ein Steuermagnetfeld $H_S$ überlagert, gesteuert einstellbar wie mit $\pm \Delta_S' H$ dargestellt. Dieses Feld muss nicht, wird aber bevorzugterweise im wesentlichen senkrecht zur Sputterfläche 1 realisiert, muss nicht, wird aber zusätzlich bevorzugterweise homogen, d.h. mit konstanter Feldstärke, angelegt.

Weil, gemäss Fig. 6, das Steuermagnetfeld $H_S$ nur für Veränderungen des schleifenförmig umlaufenden Tunnelmagnetfeldes H verantwortlich ist und nicht für dessen eigentliche Ausbildung, können die dieses Steuermagnetfeld $H_S$ erzeugenden Magnete (nicht dargestellt) wesentlich schwächer ausgebildet werden, als dies beispielsweise beim Vorgehen gemäss der US-A-5 512 150 notwendig ist.

In Fig. 6 ist ein anodischer Teil 11c schematisch dargestellt. Durch die Wirkung des Feldes $H_S$ wird die Elektronenfalle ganz oder in einem Teilabschnitt mehr oder weniger stark durch den Anodenteil 11c - der in einem Abschnitt der Schleife 5 oder an deren ganzem Umfang, so z.B. die üblicherweise vorgesehene Entladungs-Anode der Quelle - angeschnitten, womit die Elektronenfallenwirkung massiv gestört wird.

In einer besonders bevorzugten Ausführungsform wird - um die Quellenanode auszunützen - das Vorgehen gemäss Fig. 6 an einer Elektronenfalle mit einem schleifenförmig umlaufenden Magnetfeld H eingesetzt, welche an der Sputterfläche 1 zuäusserst, im Peripheriebereich, lokalisiert ist. Das Steuermagnetfeld $H_S$ wird dann vorzugsweise mittels einer peripher umlaufenden Helmholtz-Spule realisiert, wie dies noch zu erläutern sein wird.

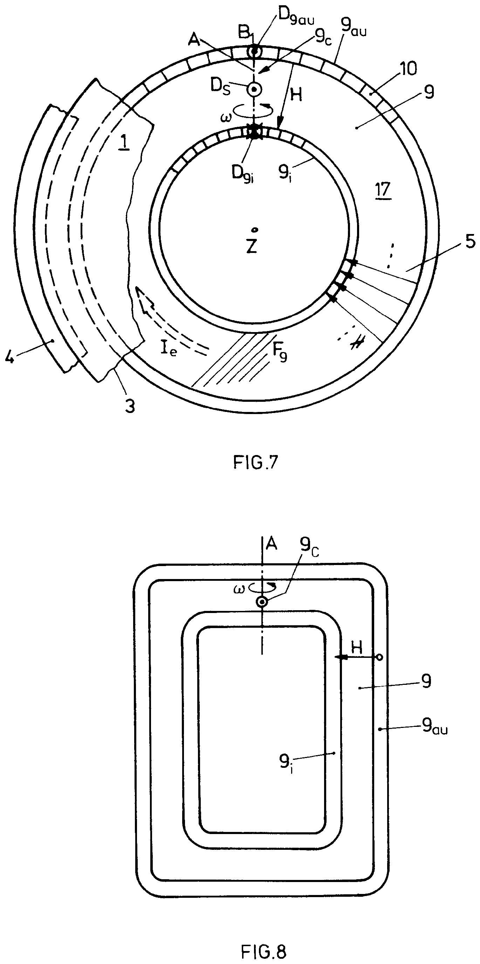

In Fig. 7 ist, wiederum schematisch, die Aufsicht auf eine erfindungsgemässe Magnetronquelle bzw. eine erfindungsgemäss gesteuerte Magnetronquelle dargestellt. Unterhalb der Targetanordnung 3, welche isoliert z.B. in einem Quellenrahmen 4 mit der Anode montiert ist, ist eine Magnetanordnung 9 mit gegenpolig angeordneten Permanentmagnetkränzen $9_i$ und $9_{au}$ vorgesehen, mit im wesentlichen senkrecht zur Sputterfläche 1 gerichteter Polarisation der Einzel-Permanentmagnete 10. Die beispielsweise Ausrichtung der magnetischen Dipole der Permanentmagnete 10 sind bei $D_{9i}$ sowie $D_{9au}$ dargestellt.

Die Permanentmagnetkränze $9_i$ und $9_{au}$ erzeugen die Schleife 5 des umlaufenden tunnelförmigen Magnetfeldes H. Dem anhand von Fig. 1 erläuterten ersten Ansatz der vorliegenden Erfindung folgend, dabei genauer demjenigen nach Fig. 3, ist eine Steuermagnetanordnung 9c vorgesehen, welche einen magnetischen Dipol $D_S$ erzeugt. Die diesen Dipol $D_S$ erzeugende Magnetanordnung 9c ist, bei diesem Ausführungsbeispiel, als gesteuert mechanisch bewegte Permanentmagnetanordnung ausgebildet und wird, insbesondere bevorzugt und wie mit $\omega$ dargestellt, um eine Achse A im wesentlichen parallel zur durch die Magnetkränze $9_i$, $9_{au}$ aufgespannten Ebene $F_9$ motorisch getrieben gedreht. Dabei liegt die Achse A in weiter bevorzugter Ausführungsform und wie noch zu beschreiben sein wird äusserst vorteilhaft, im wesentlichen in Projektionsebenen des dortigen tunnelförmigen Magnetfeldes H auf die Ebene $F_9$. Durch steuerndes Drehen des Dipols $D_S$, in Analogie zur Verstellung der Magnetanordnung 9c von Fig. 3, bis hin zu seiner Richtungsinversion, wird lokal, im Bereich $B_1$, das dort vorherrschende Magnetfeld H um $+\Delta_S H$ steuernd verändert. Wie erläutert wurde, wird damit die Elektronenfalle und der über der Sputterfläche 1 in der Schleife 5 des tunnelförmigen Magnetfeldes H umlaufende Elektronenstrom $I_e$ gemäss Fig. 1 ausgehend von einem Arbeitspunkt, z.B. mit $D_S$ unwirksam gerichtet, mehr oder weniger gestört, womit sich die Plasmaimpedanz und bei konstanter Einspeisung die Plasmadichte in der betrachteten Schleife 5 verändert. Bei voreingestellter, fixer Anoden/Kathodenspannung der Quelle kann durch entsprechende Bemessung des Dipols $D_S$ und dessen gesteuerte Ausrichtung, die Plasmaentladung in der erwähnten Schleife 5 drastisch gestört werden. Bei wie dargestellt anodennaher Elektronenfalle erfolgt praktisch Ein-/Abschalten der Elektronenfallen-Wirkung.

Wenngleich gemäss Fig. 7 die Targetanordnung 3 sowie die Magnetkränze 9i und $9_{au}$ kreisförmig ausgebildet sind, ist es ohne weiteres möglich, wie dies in Fig. 8 dargestellt ist, rechteckförmige oder noch anders geformte Targetanordnungen 3 und entsprechend geformte Magnetkränze vorzusehen, dabei die Steuerung gemäss den bisherigen Erläuterungen erfindungsgemäss, z.B. gemäss Fig. 7 vorzusehen.

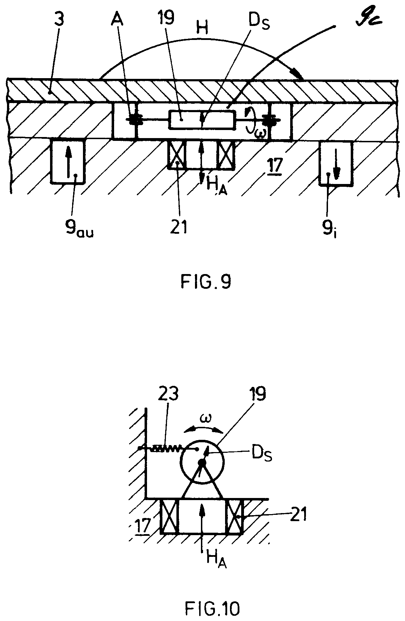

In Fig. 9 ist, weiterhin schematisch, eine heute bevorzugte Realisationsform der anhand von Fig. 7 erläuterten Steuermagnetanordnung 9c dargestellt. Auf der Trägerplatte 17, woran die Magnetkränze $9_{au}$ und $9_i$ eingebaut sind, um die Drehachse A getrieben drebeweglich und wie erläutert bezüglich des Magnetfeldes H ausgerichtet, ist ein mit dem Dipol $D_S$ polarisierter Magnetzylinder 19 schwenkgelagert. Sein Antrieb erfolgt über eine Antriebsspule 21, welche, gesteuert, ein Antriebsfeld $H_A$ erzeugt. Aufgrund der Relativposition des Magnetzylinders 19, seines Dipols $D_S$, bezüglich des Magnetfeldes H lässt sich trotz dieses starken Magnetfeldes H der Zylinder 19 durch Überwindung eines nur äusserst geringen Drehmomentes drehen, so dass mit der Spule 21 ein nur geringes Antriebsfeld $H_A$ zu erzeugen ist. Bei dieser Anordnung und Polung der Felder bzw. Magnete unterstützt das Magnetfeld H die Drehbewegung des Zylinders 19 und das Einhalten einer stabilen Endposition. Um sicherzustellen, dass der Magnetzylinder 19 nie, bezüglich des Antriebsfeldes $H_A$, in Drehmoment-neutrale Position schwenkt, wird - wie dies in Fig. 10 schematisch dargestellt ist - bevorzugterweise die Drehbewegung des Magnetzylinders 19 federnd vorgespannt, was auch ermöglicht, den Magnetzylinder 19 kontinuierlich in eine beliebige Dipol-Winkelstellung zu treiben und so eine stetige bzw. kontinuierliche, erfindungsgemässe Steuerung vorzunehmen. Dies wird vor allem an anodenferneren Elektronenfallen eingesetzt; es erfolgt eine gesteuerte Verformung und/oder stetige Wirkungsänderung der bzw. an der Elektronenfalle.

Gemäss Fig. 10 wird z.B. ein Federorgan 23, welches zwischen Trägerplatte 17 und Magnetzylinder 19 wirkt, beispielsweise eine Spiralfeder auf der Achse A, vorgesehen.

In Fig. 7 ist eine Ausführungsform dargestellt, bei der die Permanentmagnetkränze $9_i$ und $9_{au}$ kreisringförmig und bezüglich der Targetanordnung 3 stationär sind.

Es ist aber, wie bereits einleitend erläutert wurde, bekannt, die Magnetkränze unterhalb der Targetanordnung 3 als ganze Einheit zu bewegen und damit die Elektronenfalle bzw. die Schleife 5 des tunnelförmigen Magnetfeldes H im Betrieb über der Sputterfläche 1 zu verschieben. Dies wird üblicherweise in einer pendelnden bzw. umlaufenden oder rotierenden, gesteuerten Bewegung realisiert. In diesem Fall sind allerdings, wie ohne weiteres einleuchtend, die Magnetkränze entsprechend $9_i$, $9_{au}$ nicht mehr wie in Fig. 7 dargestellt kreisringförmig ausgebildet bzw. nicht mehr konzentrisch zum Zentrum Z der Targetanordnung 3. Vielmehr werden sie in diesem Falle üblicherweise oval, herz- oder nierenförmig ausgebildet. Bei der eben besprochenen Ausführungsform wird mithin der Ort der Schleife 5 des tunnelförmigen Magnetfeldes H über der Sputterfläche 1 verschoben. Andere Bauformen, wie insbesondere für grosse, rechteckförmige Targets, sind bekannt, bei denen eine pendelnde Verschiebung des Ortes höchster Plasmadichte dadurch erfolgt, dass pendelnd betriebene Magnetwalzen den Appex oder den Fusspunkt des tunnelförmigen Magnetfeldes H pendelnd hin und her verschieben. In allen erwähnten Bauformen kann das zusätzliche Steuern gemäss vorliegender Erfindung eingesetzt werden.

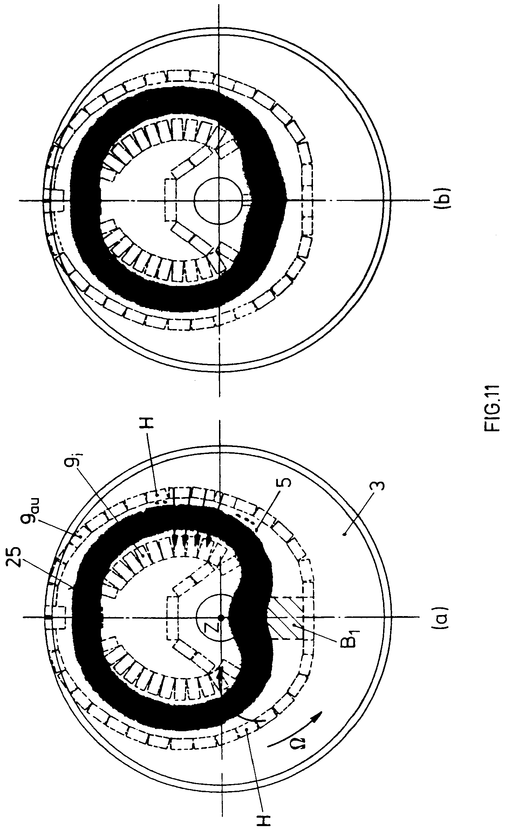

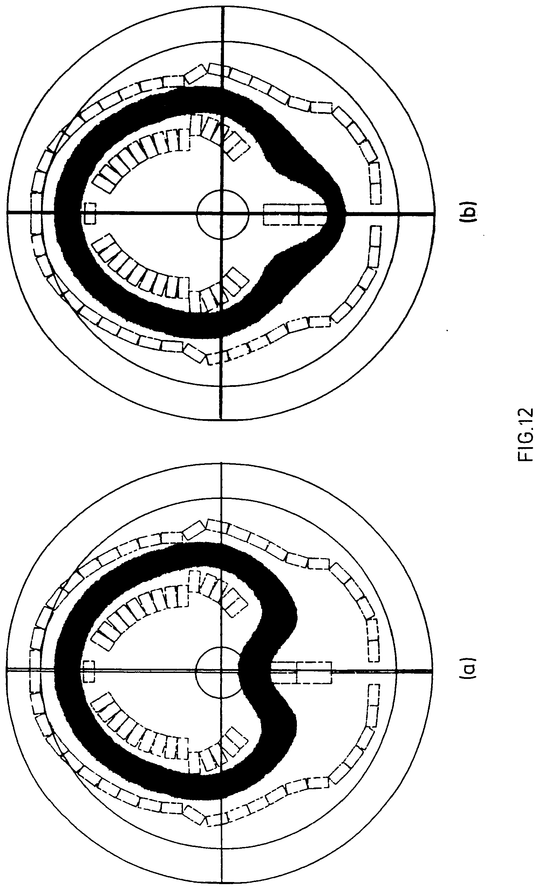

In Fig. 11 (a), (b) ist, in Aufsicht, eine erfindungsgemässe Magnetronquelle dargestellt mit einem äusseren Permanentmagnetkranz $9_{au}$, leicht nierenförmig, und, bezüglich des Zentrums Z der kreisförmigen Targetanordnung 3 exzentrisch, sowie mit einem inneren Magnetkranz $9_i$, ausgeprägt nierenförmig und das Zentrum Z aussenliegend umlaufend. Im Bereich $B_1$ ist erfindungsgemäss eine nach Fig. 3 arbeitende Steuermagnetanordnung vorgesehen (nicht dargestellt), bevorzugterweise ausgebildet, wie dies anhand der Fig. 7 bis 10 erläutert wurde. Der sich in der Schleife 5 des tunnelförmigen Magnetfeldes H ergebende "Schlauch" hoher Plasmadichte wird, wie sich aus der Betrachtung der beiden Fig. 11 ergibt, mit Hilfe der erfindungsgemässen Steuerung im Bereich $B_1$ bezüglich seiner Form gemäss (a) und (b) umgesteuert, an der, wie mit $\Omega$ dargestellt, um das Zentrum Z drehenden Magnetkranzanordnung und Steuermagnetanordnung. Weil der Ansteuerungsbereich $B_1$ fern von der Entladungsanode (nicht dargestellt) liegt, kann hier ohne weiteres stetig umgesteuert werden. Dies gilt auch bezüglich der folgenden Figur 12.

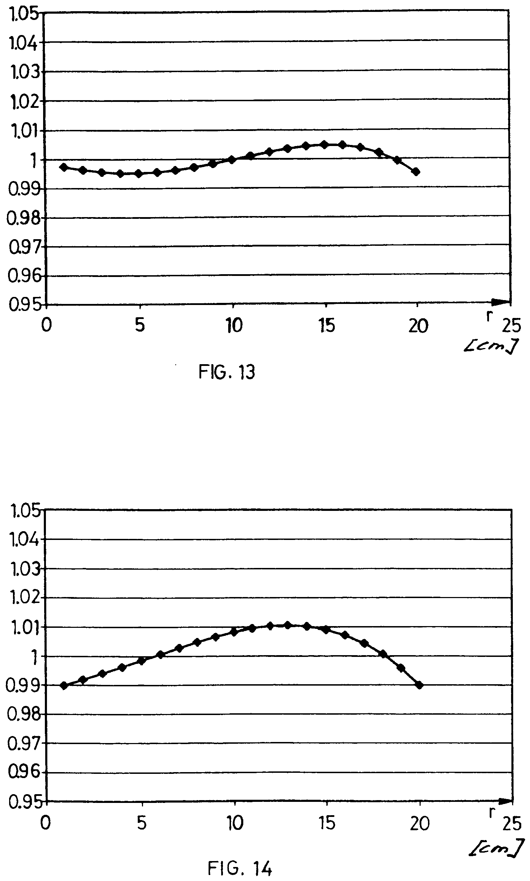

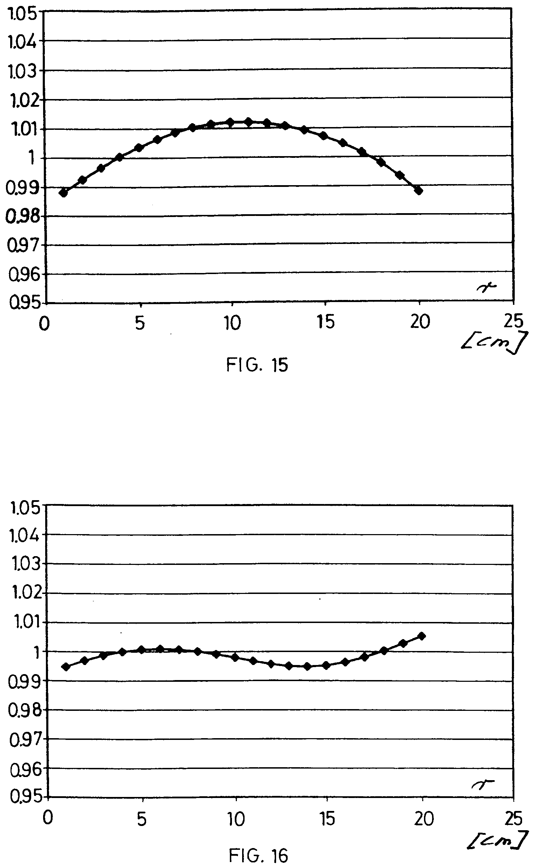

In den Fig. 12(a) und (b) ist eine weitere erfindungsgemäss umgesteuerte Quellenkonfiguration in Analogie zu Fig. 11(a) und (b) dargestellt, in den Fig. 13, 14, 15 und 16 die je nach Ansteuerung der Quellen gemäss den Fig. 11 bzw. 13 erreichten bzw. angesteuerten Schichtdickenverteilungen an einem jeweiligen planen, beschichteten Substrat, normiert auf die Solldicke.

Bei den Ausführungsformen gemäss den Figuren 11 und 12 wird die jeweilige Elektronenfalle in einem Bereich $B_1$ lokal verändert, der abseits anodisch betriebener Teile ist. Daher erfolgt weniger eine Veränderung der Elektronenfallen-Wirkung an sich, sondern die Elektronenfalle wird umgeformt.

Durch die zeitlich gesteuerte Umformung der Elektronenfalle, z.B. nach einem Zeit-Steuerprogramm, kann die Zerstäubungsverteilung an der Sputterfläche zusätzlich optimiert werden.

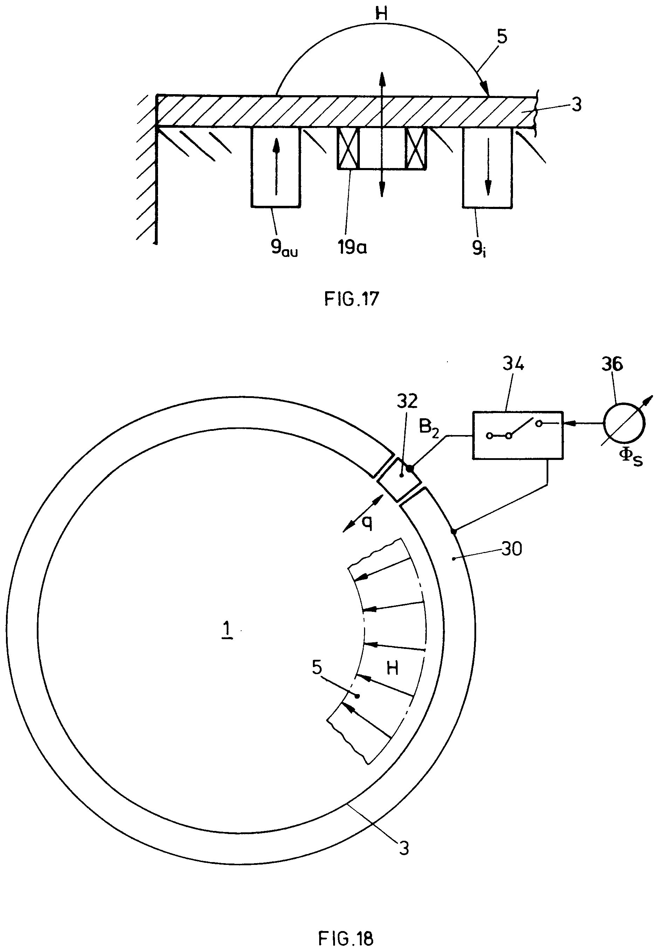

Insbesondere wenn die Schleife 5 des tunnelförmigen Magnetfeldes über der Sputterfläche nicht bewegt wird, kann anstelle oder ergänzend zu einer mechanisch steuernd bewegten Steuer-Permanentmagnetanordnung unterhalb der Targetanordnung 3, wie in Fig. 17 dargestellt, eine Elektromagnetanordnung 19a lokal vorgesehen sein, um das tunnelförmige Feld H erfindungsgemäss zu ändern.

Insbesondere wenn die Schleife 5 des tunnelförmigen Magnetfeldes über der Sputterfläche 1 stationär ist, eignet sich auch die in Fig. 18 schematisch dargestellte Ausführungsvariante unter ihrem ersten Ansatz, wobei Fig. 18 nicht Teil der Erfindung ist. Die Targetanordnung 3 mit der Sputterfläche 1 wird, elektrisch isoliert, von einem Anodenring 30 umgeben. Zwischen Anodenring 30 und Sputterfläche 1, als Kathodenfläche, ergibt sich das beispielsweise in Fig. 1 eingetragene elektrische Feld E. In einem Bereich $B_2$ auch gemäss Fig. 1 wird eine Steueranode 32 vorgesehen. Wie mit Möglichkeitenumschalter 34 schematisiert, wird die Steueranode 32 mechanisch gegen bzw. in die Magnetfeldschleife 5 eingefahren bzw. rückgeholt - q - und/oder stationär mit einer Steuerquelle 36 auf gesteuert variables Potential $\phi_S$ gelegt. Dadurch wird die in Fig. 5 schematisierte Ausführungsform realisiert.

Dieses Vorgehen, gegebenenfalls kombiniert mit einer - sich bei Verschiebung ergebenden - lokalen Veränderung des Magnetfeldes H, kann insbesondere auch dann bei bezüglich der Sputterfläche 1 im Betrieb bewegter Schleife 5 des tunnelförmigen Magnetfeldes H eingesetzt werden, wenn im Zentrumsbereich Z der Targetanordnung (nicht dargestellt) eine Steuerelektrode analog zur Steuerelektrode 32 von Fig. 18 eingebaut werden kann.

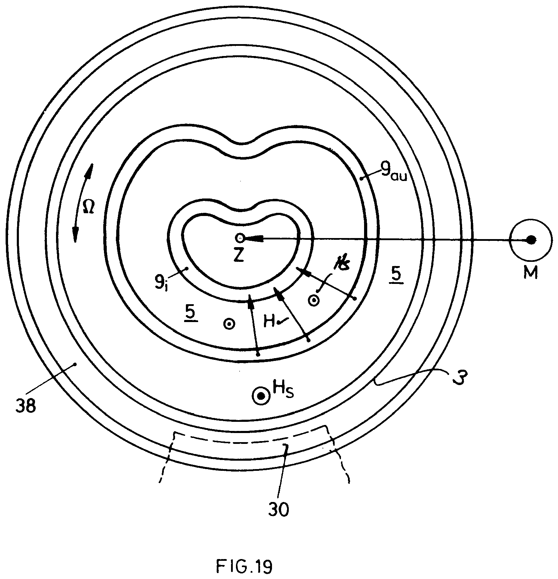

In Fig. 19 ist eine Ausführungsvariante nach dem zweiten anhand von Fig. 6 vorerläuterten Ansatz der vorliegenden Erfindung dargestellt. Nur beispielsweise handelt es sich dabei um eine Magnetronquelle, bei der die Schleife 5 des tunnelförmigen Feldes H aufgebaut zwischen Permanentmagnetkränzen $9_{au}$ und $9_i$ während des Betriebes um das Zentrum Z der Targetanordnung 3, wie mit dem Antrieb M schematisiert, gesteuert getrieben bewegt wird. Das bereits anhand von Fig. 6 erläuterte, dem tunnelförmigen Magnetfeld H überlagerte Steuermagnetfeld $H_S$ wird beispielsweise durch eine an der Quelle stationär peripher vorgesehene Helmholtz-Spule 38 erzeugt. Mit diesem Feld $H_S$ kann die Ausdehnung des Tunnels gesteuert werden und bei entsprechender Anordnung bezüglich der Anode (gestrichelt bei 30) in diese hinein gezogen werden, was wiederum den erwünschten massiven Störeffekt der Elektronenfallenwirkung ergibt.

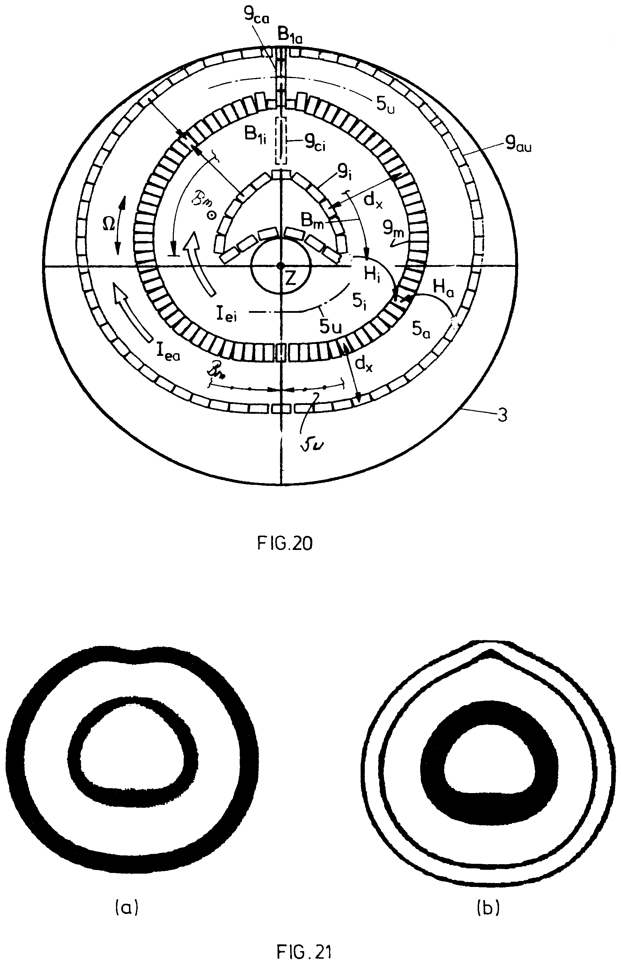

In Fig. 20 sind in Aufsicht die Permanentmagnetkränze $9_{au}$, $9_m$, $9_i$ dargestellt zur Realisation von zwei Schleifen $5_a$, $5_i$ des tunnelförmigen Magnetfeldes $H_a$ und $H_i$. Die Permanentmagnetkränze werden - wie mit $\Omega$ dargestellt - an der hier beispielsweise dargestellten Quelle um das Zentrum Z der als Kreisscheibe gebildeten Targetanordnung 3 gedreht. In den Bereichen $B_{1a}$ und/oder $B_{1i}$ sind Steuermagnetanordnungen $9_{ca}$ bzw. $9_{ci}$ in Analogie zu Fig. 3 vorgesehen, bevorzugterweise aufgebaut, wie dies anhand der Fig. 7 bis 10 erläutert wurde. In den Fig. 21(a) und (b) ist die Wirkung der Steuermagnetanordnung $9_{ca}$ gemäss Fig. 20 dargestellt. Wird durch diese Anordnung $9_{ca}$ die äussere Elektronenfalle in Anodennahem Bereich gestört (Übergang von Fig. (a) nach (b)), so ergibt sich darin eine massgebliche Erhöhung der Plasmaimpedanz. Der Entladestrom komutiert in die innere Elektronenfalle mit der Schleife $5_i$. Damit wird mit dem erfindungsgemässen Vorgehen nicht nur die Plasmadichte bzw. -verteilung in einer Ringzone entsprechend einer Schleife 5 des tunnelförmigen Magnetfeldes angesteuert, sondern die Verteilung der Plasmadichte zwischen zwei und mehr derartigen Schleifen $5_i$, $5_a$.

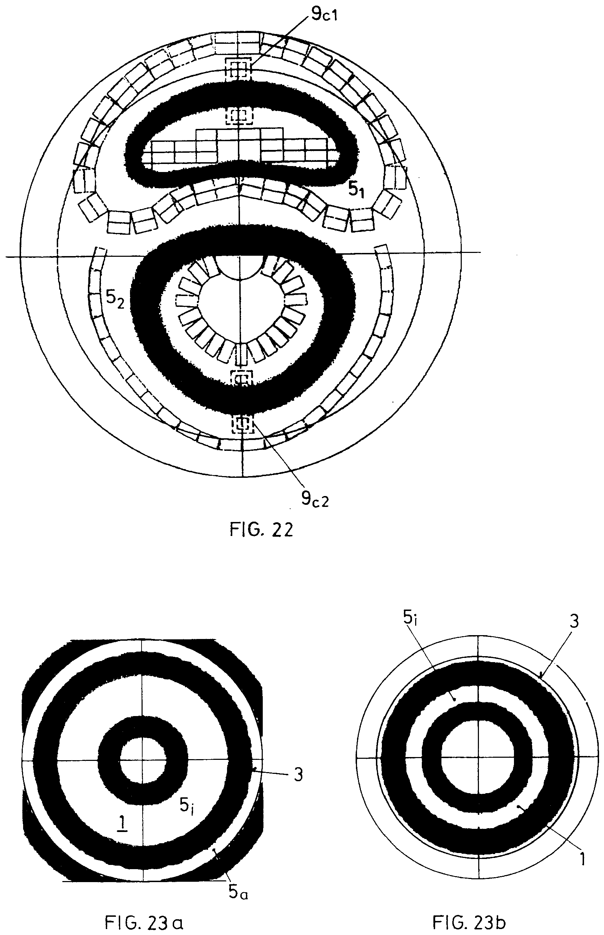

In Fig. 22 ist, in Darstellung analog zu derjenigen von Fig. 21, dargestellt, wie die beispielsweise zwei vorgesehenen Schleifen $5_1$, $5_2$ tunnelförmiger Magnetfelder nicht wie in Fig. 21 ineinander, sondern nebeneinander angeordnet sein können und durch Vorsehen von Steuermagnetanordnungen $9_{c1}$ und/oder $9_{c2}$, wie nur beispielsweise gestrichelt angedeutet, die Plasmadichteverteilung zwischen den beiden Schleifen $5_1$ und $5_2$ verändert werden kann.

In Fig. 23(a), (b) ist die Wirkung der anhand von Fig. 6 sowie Fig. 19 erläuterten Ausführungsform der Erfindung unter ihrem zweiten Ansatz dargestellt. Dabei sind zwei konzentrische Schleifen $5_a$, $5_i$ tunnelförmiger Magnetfelder realisiert. Durch Ansteuerung des überlagerten Magnetfeldes $\pm\Delta_S$'H gemäss Fig. 6, bevorzugterweise mittels der anhand von Fig. 19 erläuterten Helmholtz-Spulenanordnung 38, wird (Übergang von Fig. 23(a) zu Fig. (b)) die äussere Schleife $5_a$ radial nach aussen in die Anode verbreitert, und damit das die Elektronenfalle mitbildende Magnetfeld H: Es wird die äussere Schleife $5_a$ von der Anode (nicht dargestellt) an der Peripherie der Targetanordnung 3 mehr und mehr angeschnitten, es erlischt die dortige Plasmaentladung, weil die Elektronen mehr und mehr an der peripheren Anode der Plasmaentladungsstrecke abgezogen werden. Es verbleibt durch die erwähnte Komutierung eine innere Schleife $5_i$ bzw. innere Elektronenfalle nun erhöhter Plasma-Dichte bzw. -Entladungsleistung. Dies bewirkt eine Verlagerung der Sputterzone und damit der Verteilung der Beschichtungsrate. Somit kann auch hier die Sputterratenverteilung über der Sputterfläche gesteuert eingestellt werden.

In Fig. 20 ist am praktischen Ausführungsbeispiel sowohl, strichpunktiert, die erwähnte Bezugsgrösse "mittlerer Umfang" 5u eingetragen, sowie der lokale Polbereichsabstand $d_x$.

Die mittlere Umfangslänge 5u ergibt sich aus der gemittelten Länge der gemeinsam eine Elektronenfalle mitdefinierenden Permanentmagnet-Kränze 9au/9m bzw. 9m/9i, während der mittlere Polbereichsabstand sich aus der Mittelung der Polbereichsabstände $d_x$ ergibt, gemittelt an Bereichen $B_m$, an denen die Permanentmagnetkränze mindestens genähert parallel verlaufen.

Ein weiterer höchst positiver Effekt der vorliegenden Erfindung wird nun ersichtlich:

Werden an der erfindungsgemässen Magnetronquelle zwei oder mehr schleifenförmig umlaufende, tunnelförmig umlaufende Magnetfelder vorgesehen, welche jeweils mindestens vornehmlich in Zonen unterschiedlicher Materialien der Targetanordnung wirken, so wird durch Einsatz der erfindungsgemässen Steuerung ermöglicht, die Sputterratenverteilung der zwei oder mehr Materialien über der Zeit zu steuern und damit die Beschichtungsratenverteilung aus diesen Materialien an einem Werkstück bzw. Substrat sowohl bei nichtreaktiven wie auch bei reaktiven Beschichtungsverfahren.

Zur Festlegung der bevorzugten lokalen Bereiche $B_1$ bzw. $B_2$ gemäss Fig. 1 wurde eingangs deren Länge $l_B$ einerseits mit der mittleren Umfangslänge der jeweiligen Elektronenfalle bzw. der geschlossenen Schleife tunnelförmigen Magnetfeldes (in Aufsicht) in Beziehung gesetzt, sowie zum jeweiligen Polbereichs-Abstand d.

Im Folgenden werden weitere Beispiele genannt.

Ein Beispiel betrifft ein Verfahren zur Steuerung der Plasmadichte-Verteilung über einer Targetanordnung einer Magnetronsputterquelle, bei der über einer Targetsputterfläche der Targetanordnung mindestens eine Elektronenfalle erzeugt wird mit einem Magnetfeld, das durch eine Magnetanordnung gebildet wird und das, in Aufsicht auf die Targetanordnung, eine in sich geschlossene, umlaufende Schleife bildet und, in Targetanordnungs-Querschnittsrichtung betrachtet, tunnelförmig ist, und worin, aufgrund der Schleife des tunnelförmigen Magnetfeldes sowie eines dazu gewinkelten, elektrischen Feldes, das zwischen einer Anode und der Targetanordnung als Kathode ausgebildet wird, ein Elektronenstrom gebildet wird, der entlang und in der Schleife eine Stromschleife bildet und damit dort einen Ort erhöhter Plasmadichte. Dabei wird entlang der Schleife des umlaufenden, tunnelförmigen Magnetfeldes dieses tunnelförmige Magnetfeld in einem Bereich der Schleife steuernd verändert, wobei man die mindestens eine Elektronenfalle über der Targetsputterfläche mittels der das tunnelförmige Magnetfeld bildenden Magnetanordnung verschiebt und die gesteuerte Veränderung mittels einer Elektromagnetanordnung und/oder einer mechanisch gesteuert bewegten Permanentmagnetanordnung und/oder mittels eines mechanisch gesteuert bewegten ferromagnetischen Shunts vornimmt.

In einem weiteren Beispiel verändert man das tunnelförmige Magnetfeld innerhalb eines Bereiches der Schleife, dessen Länge höchstens 1/3 der mittleren Umfanglänge der Schleife beträgt, vorzugsweise höchstens 1/4.

In einem weiteren Beispiel weist die das tunnelförmige Magnetfeld bildende Magnetanordnung Polbereiche auf und man nimmt bei einem mittleren Polabstand der Polbereiche, an denen das tunnelförmige Magnetfeld aus der Targetanordnung aus- bzw. wieder eintritt, d, die gesteuerte Veränderung auf einer Länge der Schleife $l_B$ vor, für die gilt:

$$0 < l_B \leq 4\,d$$

vorzugsweise

$$0 < l_B \leq 2\,d$$

insbesondere bevorzugt gilt:

$$0 < l_B \leq d.$$

In einem weiteren Beispiel steuert man das Mass, mit welchem die Anode in das tunnelförmige Magnetfeld eingreift, durch die lokale Veränderung des E-Felds an der kathodischen

Targetsputterfläche.

In einem weiteren Beispiel verändert man das tunnelförmige Magnetfeld durch lokalen, steuernden Eingriff auf dessen Erzeuger.

In einem weiteren Beispiel wird über der Targetanordnung mindestens zwei Elektronenfallen erzeugt, wobei die gesteuerte Veränderung an mindestens einer der Elektronenfallen realisiert wird und damit das Plasmadichteverhältnis zwischen den Elektronenfallen gesteuert verändert wird.

In einer weiteren Ausführung des vorangehenden Beispiel wird die eine Elektronenfalle innerhalb der andern realisiert wird.

In einer weiteren Ausführung des vorangehenden Beispiels werden die beiden Elektronenfallen nebeneinanderliegend realisiert.

In einem weiteren Beispiel wird mindestens eine Elektronenfalle zyklisch über der Targetsputterfläche verschoben.

In einem weiteren Beispiel verändert man mit der gesteuerten Veränderung die Form der Schleife der Elektronenfalle gesteuert oder schwächt bzw. verstärkt man die Elektronenfalle gesteuert bis hin zu deren Ab- und Aufschalten.

In einem weiteren Beispiel nimmt man die gesteuerte Veränderung diskret in mindestens einem Schritt vom einen in den anderen Zustand vor oder kontinuierlich, vorzugsweise nach einem vorgegebenen Zeitprofil.

In einem weiteren Beispiel sieht man ein dem tunnelförmigen Magnetfeld überlagertes Steuermagnetfeld vor.

In einer weiteren Ausführung wird wählt man die den jeweiligen den Elektronenfallen zugeordneten Oberflächenbereichen der Targetanordnung aus unterschiedlichen Materialien.

Ein weiteres Beispiel betrifft ferner ein Verfahren zur Fertigung beschichteter Substrate, wobei man die Verteilung der Beschichtungsrate und/oder des Beschichtungsmaterials mindestens an einem Teil der Beschichtung durch Steuerung einer Magnetronquelle nach einem der vorangehenden Beispiele steuert.

Ein weiteres Beispiel betrifft ferner eine Magnetronsputterquelle mit einer Targetanordnung mit einer Targetsputterfläche, einer Magnetanordnung auf der der Targetsputterfläche abgekehrten Targetanordnungsseite, welche Magnetanordnung über der Targetsputterfläche mindestens eine in sich geschlossene Schleife eines tunnelförmig aus der Targetsputterfläche aus- und in die Targetsputterfläche wieder eintretenden Magnetfeldes erzeugt, weiter einer bezüglich Targetanordnung anodisch betriebenen Elektrodenanordnung, wobei eine steuerbare Magnetanordnung lokal in einem Bereich entlang der Schleife auf das Magnetfeld verändernd eingreift, dadurch gekennzeichnet, dass die steuerbare Magnetanordnung eine Elektromagnetanordnung und/oder eine mechanisch gesteuert bewegbare Permanentmagnetanordnung und/oder eine mechanisch gesteuerte, bewegbare ferromagnetische Shuntanordnung umfasst und dass die Magnetanordnung, welche das tunnelförmig aus der Targetsputterfläche aus- und in die Targetsputterfläche wieder eintretende Magnetfeld (H) erzeugt, bezüglich der Targetanordnung getrieben bewegbar ist.

In einem weiteren Beispiel wird die steuerbare Magnetanordnung einem Bereich der Schleife verändert, dessen Länge höchstens 1/3 des mittleren Umfangs der Schleife beträgt, vorzugsweise höchstens 1/4 ist.

In einem weiteren Beispiel verhalten sich der mittlere Abstand von Magnetpolen der das tunnelförmige Magnetfeld bildenden Magnetanordnung, die das tunnelförmige Magnetfeld erzeugen - d - und die Länge - $l_B$ - des Bereiches, worin die steuerbare Magnetanordnung an der Schleife eingreift, wie folgt:

$$0 < l_B \leq 4\,d$$

vorzugsweise

$$0 < l_B \leq 2\,d$$

insbesondere bevorzugt

$$0 < l_B \leq d.$$

In einem weiteren Beispiel umfasst die steuerbare Magnetanordnung, welche lokal in das tunnelförmige Magnetfeld eingreift, mindestens eine Helmholtzspulenanordnung.

In einem weiteren Beispiel umfasst die steuerbare Magnetanordnung, welche lokal in das tunnelförmige Magnetfeld eingreift, mindestens einen getrieben drehbeweglich gelagerten Magnetzylinder.

In einem weiteren Beispiel umfasst eine Antriebsvorrichtung für den Magnetzylinder eine Spulenanordnung, deren Feld auf einen magnetischen Dipol des Magnetzylinders wirkt.

In einem weiteren Beispiel sind mehr als eine das tunnelförmige Magnetfeld bildende Magnetanordnungen vorgesehen, welche je ein tunnelförmig aus der Targetsputterfläche aus- und die Targetsputterfläche wieder eintretendes Magnetfeld erzeugen.

In einem weiteren Beispiel wirkt die steuerbare Magnetanordnung, welche lokal in ein tunnelförmiges Magnetfeld eingreift, mindestens auf eines der durch die Magnetanordnungen erzeugten tunnelförmig aus der Targetsputterfläche aus- und in die Targetsputterfläche wieder eintretenden Magnetfelder.

In einem weiteren Beispiel bestehen die Targetsputterflächen, durch welche je ein tunnelförmig aus der Targetsputterfläche aus- und die Targetsputterfläche wieder eintretendes Magnetfeld erzeugt wird, im Bereich der erwähnten Magnetfelder aus unterschiedlichen Materialien.

Ein weiteres Beispiel betrifft ferner eine Sputterbeschichtungskammer mit einer Magnetronsputterquelle nach einem der vorangehenden Beispiele der genannten Magnetronsputterquelle.

Ein weiteres Beispiel betrifft ferner eine Vakuumbehandlungsanlage mit mindestens einer der beispielhaften Sputterbeschichtungskammern.

**Patentansprüche**

1. Verfahren zur Steuerung der Plasmadichte-Verteilung über einer Targetanordnung (3) einer Magnetronsputterquelle, bei der über einer Targetsputterfläche (1) der Targetanordnung (3) mindestens eine Elektronenfalle erzeugt wird mit einem Magnetfeld (H), das durch eine Magnetanordnung ($9_i$, $9_m$, $9_a$, $9_{au}$) gebildet wird und das, in Aufsicht auf die Targetanordnung (3), eine in sich geschlossene, umlaufende Schleife (5) bildet und, in Targetanordnungs-Querschnittsrichtung betrachtet, tunnelförmig ist, und worin, aufgrund der Schleife (5) des tunnelförmigen Magnetfeldes (H) sowie eines dazu gewinkelten, elektrischen Feldes (E), das zwischen einer Anode und der Targetanordnung (3) als Kathode ausgebildet wird, ein Elektronenstrom ($I_e$) gebildet wird, der entlang und in der Schleife (5) eine Stromschleife bildet und damit dort einen Ort erhöhter Plasmadichte, **dadurch gekennzeichnet, dass** entlang der Schleife (5) des umlaufenden, tunnelförmigen Magnetfeldes (H) dieses tunnelförmige Magnetfeld (H) in einem Bereich (B1) der Schleife (5) steuernd verändert wird ($\pm\Delta_S H$), wobei man die mindestens eine Elektronenfalle über der Targetsputterfläche (1) mittels der das tunnelförmige Magnetfeld (H) bildenden Magnetanordnung (9i, 9m, 9a, 9au) verschiebt und die gesteuerte Veränderung mittels einer Elektromagnetanordnung (19a, 38) und/oder einer mechanisch gesteuert bewegten Permanentmagnetanordnung (19) und/oder mittels eines mechanisch gesteuert bewegten ferromagnetischen Shunts (9d) vornimmt, wobei die steuernde Elektromagnet- und/oder Permanentmagnetanordnung und/oder Shuntanordnung zusammen mit der oder den Elektronenfallen bewegt wird bzw. werden.

2. Verfahren nach Anspruch 1, **dadurch gekennzeichnet, dass** man das tunnelförmige Magnetfeld (H) innerhalb eines Bereiches ($B_1$) der Schleife (5) verändert, dessen Länge ($l_B$) höchstens 1/3 der mittleren Umfanglänge (U) der Schleife (5) beträgt, vorzugsweise höchstens 1/4.

3. Verfahren nach einem der Ansprüche 1 oder 2, **dadurch gekennzeichnet, dass** die das tunnelförmige Magnetfeld (H) bildende Magnetanordnung ($9_i$, $9_m$,

$9_a$, $9_{au}$) Polbereiche aufweist, an denen das tunnelförmige Magnetfeld (H) aus der Targetanordnung aus- bzw. wieder eintritt, und dass man bei einem mittleren Polabstand (d) der Polbereiche die gesteuerte Veränderung auf einer Länge der Schleife $l_B$ vornimmt, für die gilt:

$$0 < l_B \leq 4\,d$$

Vorzugsweise

$$0 < l_B \leq 2\,d$$

insbesondere bevorzugt gilt:

$$0 < l_B \leq d.$$

4. Verfahren nach einem der Ansprüche 1 bis 3, **dadurch gekennzeichnet, dass** man das Mass, mit welchem die Anode in das tunnelförmige Magnetfeld (H) eingreift, durch eine lokale Veränderung steuert.

5. Verfahren nach einem der Ansprüche 1 bis 4, **dadurch gekennzeichnet, dass** man das tunnelförmige Magnetfeld (H) durch lokalen, steuernden Eingriff auf dessen Erzeuger ($9_a$) verändert.

6. Verfahren nach einem der Ansprüche 1 bis 5, wobei über der Targetanordnung (3) mindestens zwei Elektronenfallen erzeugt werden, **dadurch gekennzeichnet, dass** die gesteuerte Veränderung an mindestens einer der Elektronenfallen realisiert wird und damit das Plasmadichteverhältnis zwischen den Elektronenfallen gesteuert verändert wird.

7. Verfahren nach Anspruch 6, **dadurch gekennzeichnet, dass** die eine Elektronenfalle innerhalb der andern realisiert wird.

8. Verfahren nach Anspruch 6, **dadurch gekennzeichnet, dass** die beiden Elektronenfallen nebeneinanderliegend realisiert werden.

9. Verfahren nach einem der Ansprüche 1 - 8, **dadurch gekennzeichnet, dass** mindestens eine Elektronenfalle zyklisch über der Targetsputterfläche verschoben wird.

10. Verfahren nach einem der Ansprüche 1 bis 8, **dadurch gekennzeichnet, dass** man mit der gesteuerten Veränderung die Form der Schleife der Elektronenfalle gesteuert verändert oder die Elektronenfalle gesteuert schwächt bzw. verstärkt bis hin zu deren Ab- und Aufschalten.

**11.** Verfahren nach einem der Ansprüche 1 - 10, **dadurch gekennzeichnet, dass** man die gesteuerte Veränderung diskret in mindestens einem Schritt vom einen in den anderen Zustand vornimmt oder kontinuierlich, vorzugsweise nach einem vorgegebenen Zeitprofil.

**12.** Verfahren nach einem der Ansprüche 1 bis 11, **dadurch gekennzeichnet, dass** man ein dem tunnelförmigen Magnetfeld (H) überlagertes Steuermagnetfeld (H$_s$) vorsieht.

**13.** Verfahren nach Anspruch 6, **dadurch gekennzeichnet, dass** man die den jeweiligen den Elektronenfallen zugeordneten Oberflächenbereichen der Targetanordnung aus unterschiedlichen Materialien wählt.

**14.** Verfahren zur Fertigung beschichteter Substrate, **dadurch gekennzeichnet, dass** man die Verteilung der Beschichtungsrate und/oder des Beschichtungsmaterials mindestens an einem Teil der Beschichtung durch Steuerung einer Magnetronsputterquelle nach einem der Ansprüche 1 - 13 steuert.

**15.** Magnetronsputterquelle mit einer Targetanordnung (3) mit einer Targetsputterfläche (1), einer Magnetanordnung (9, 9$_a$, 9$_{au}$, 9$_m$, 9$_i$) auf der der Targetsputterfläche (1) abgekehrten Targetanordnungsseite, welche Magnetanordnung über der Targetsputterfläche (1) mindestens eine in sich geschlossene Schleife (5) eines tunnelförmig aus der Targetsputterfläche (1) aus- und in die Targetsputterfläche (1) wieder eintretenden Magnetfeldes (H) erzeugt, weiter einer bezüglich Targetanordnung anodisch betriebenen Elektrodenanordnung (11, 11c, 30), wobei eine steuerbare Magnetanordnung in einem Bereich entlang der Schleife auf das Magnetfeld (H) verändernd ($\triangle_{SH}$) eingreift, **dadurch gekennzeichnet, dass** die steuerbare Magnetanordnung eine Elektromagnetanordnung (19a) und/oder eine mechanisch gesteuert bewegbare Permanentmagnetanordnung (19) und/oder eine mechanisch gesteuerte, bewegbare ferromagnetische Shuntanordnung (9d) umfasst und dass die Magnetanordnung (9$_i$, 9$_m$, 9$_a$, 9$_{au}$), welche das tunnelförmig aus der Targetsputterfläche (1) aus- und in die Targetsputterfläche (1) wieder eintretende Magnetfeld (H) erzeugt, bezüglich der Targetanordnung (3) getrieben bewegbar ist, wobei die steuernde Elektromagnet-und/oder Permanentmagnetanordnung und/oder Shuntanordnung zusammen mit der oder den Elektronenfallen bewegbar ist bzw. sind.

**16.** Magnetronsputterquelle nach Anspruch 15, **dadurch gekennzeichnet, dass** die steuerbare Magnetanordnung einem Bereich (B$_1$) der Schleife (5) verändert wird, dessen Länge höchstens 1/3 des mittleren Umfangs der Schleife beträgt, vorzugsweise höchstens 1/4 ist.

**17.** Magnetronsputterquelle nach einem der Ansprüche 15 oder 16, da-durch gekennzeichnet, dass der mittlere Abstand (d) von Magnetpolen der das tunnelförmige Magnetfeld (H) bildenden Magnetanordnung (9$_i$, 9$_m$, 9$_a$, 9$_{au}$), die das tunnelförmige Magnetfeld erzeugen - d - und die Länge - l$_B$ - des Bereiches, worin die steuerbare Magnetanordnung an der Schleife eingreift, sich wie folgt verhalten:

$$0 < l_B \leq 4\ d$$

vorzugsweise

$$0 < l_B \leq 2\ d$$

insbesondere bevorzugt

$$0 < l_B \leq d.$$

**18.** Magnetronsputterquelle nach einem der Ansprüche 15 bis 17, **dadurch gekennzeichnet, dass** die steuerbare Magnetanordnung (19) lokal in das tunnelförmige Magnetfeld eingreift und mindestens eine Helmholtzspulenanordnung (38) umfasst.

**19.** Magnetronsputterquelle nach einem der Ansprüche 15 - 18, **dadurch gekennzeichnet, dass** die steuerbare Magnetanordnung (19) lokal in das tunnelförmige Magnetfeld eingreift und mindestens einen getrieben drehbeweglich gelagerten Magnetzylinder (19) umfasst.

**20.** Magnetronsputterquelle nach Anspruch 19, **dadurch gekennzeichnet, dass** eine Antriebsvorrichtung für den Magnetzylinder (19) eine Spulenanordung (21) umfasst, deren Feld (H$_A$) auf einen magnetischen Dipol (D$_S$) des Magnetzylinders (19) wirkt.

**21.** Magnetronsputterquelle nach einem der Ansprüche 15 bis 20, **dadurch gekennzeichnet, dass** mehr als eine das tunnelförmige Magnetfeld bildende Magnetanordnungen (9$_i$, 9$_m$, 9$_a$, 9$_{au}$) vorgesehen sind, welche je ein tunnelförmig aus der Targetsputterfläche (1) aus- und die Targetsputterfläche (1) wieder eintretendes Magnetfeld (H$_a$, H$_i$) erzeugen.

**22.** Magnetronsputterquelle nach Anspruch 21, **dadurch gekennzeichnet, dass** die steuerbare Magnetanordnung (19), welche lokal in das tunnelförmige Magnetfeld eingreift, mindestens auf eines der durch die Magnetanordnungen erzeugten tunnelförmig aus der Targetsputterfläche aus- und in die Targetsputterfläche wieder eintretenden Magnetfelder (H_i, H_a) wirkt.

**23.** Magnetronsputterquelle nach Anspruch 21 oder 22, **dadurch gekennzeichnet, dass** die Targetsputterflächen, durch welche je ein tunnelförmig aus der Targetsputterfläche (1) aus- und die Targetsputterfläche (1) wieder eintretendes Magnetfeld (H_a, H_i) erzeugt wird, im Bereich der erwähnten Magnetfelder (H_i, H_a) aus unterschiedlichen Materialien bestehen.

**24.** Sputterbeschichtungskammer mit einer Magnetronsputterquelle nach einem der Ansprüche 15 - 23.

**25.** Vakuumbehandlungsanlage mit mindestens einer Sputterbeschichtungskammer nach Anspruch 24.

**Claims**

**1.** A method for controlling a plasma density distribution over a target arrangement (3) of a magnetron sputter source, in which at least one electron trap is generated over a target sputter surface (1) of the target arrangement (3) using a magnetic field (H), which is formed by a magnet arrangement ($9_i$, $9_m$, $9_a$, $9_{au}$) and which, in a top view of the target arrangement (3), forms a closed, circumferential loop (5), and, observed in the target arrangement cross-sectional direction, is tunnel-shaped, and in which, as a result of the loop (5) of the tunnel-shaped magnetic field (H) and an electrical field (E) angled thereto, which is formed between an anode and the target arrangement (3) as a cathode, an electron current ($I_e$) is formed, which forms a current loop along and in the loop (5) and therefore a location of increased plasma density therein, **characterized in that**, along the loop (5) of the circumferential, tunnel-shaped magnetic field (H), this tunnel-shaped magnetic field (H) is varied in a controlling manner ($+\Delta_S H$) in a region (B1) of the loop (5), wherein the at least one electron trap is shifted over the target sputter surface (1) by means of the magnet arrangement ($9_i$, $9_m$, $9_a$, $9_{au}$) forming the tunnel-shaped magnetic field (H) and the controlled change is performed by means of an electromagnet arrangement (19a, 38) and/or a mechanically controlled moving permanent magnet arrangement (19) and/or by means of a mechanically controlled moved ferromagnetic shunt (9d), wherein the controlling electromagnet and/or permanent magnet arrangement and/or shunt arrangement is/are moved together with the electron trap or traps.

**2.** The method according to Claim 1, **characterized in that** the tunnel-shaped magnetic field (H) is changed within a region (B_1) of the loop (5), whose length (l_B) is at most 1/3 of the mean circumferential length (U) of the loop (5), preferably at most 1/4.

**3.** The method according to any one of Claims 1 or 2, **characterized in that** the magnet arrangement ($9_i$, $9_m$, $9_a$, $9_{au}$) forming the tunnel-shaped magnetic field (H) has pole regions, at which the tunnel-shaped magnetic field (H) exits from and/or reenters the target arrangement, and, with a mean pole spacing (D) of the pole regions, the controlled change is performed on a length of the loop $l_B$, for which the following applies:

$$0 < l_B \leq 4\,d,$$

preferably

$$0 < l_B \leq 2\,d,$$

particularly preferably

$$0 < l_B \leq d.$$

**4.** The method according to any one of Claims 1 to 3, **characterized in that** the amount with which the anode engages in the tunnel-shaped magnetic field (H) is controlled by a local change.

**5.** The method according to any one of Claims 1 to 4, **characterized in that** the tunnel-shaped magnetic field (H) is changed by local controlling intervention on the generator ($9_a$) thereof.

**6.** The method according to any one of Claims 1 to 5, wherein at least two electron traps are generated via the target arrangement (3), **characterized in that** the controlled change is implemented on at least one of the electron traps and the plasma density ratio between the electron traps is therefore changed in a controlled manner.

**7.** The method according to Claim 6, **characterized in that** one electron trap is implemented inside the other.

**8.** The method according to Claim 6, **characterized in that** the two electron traps are implemented located adjacent to one another.

**9.** The method according to any one of Claims 1 to 8, **characterized in that** at least one electron trap is cyclically displaced over the target sputter surface.

**10.** The method according to any one of Claims 1 to 8, **characterized in that** the shape of the loop of the electron trap is changed in a controlled manner using the controlled change or the electron traps are weakened or strengthened in a controlled manner until they are turned on and off.

**11.** The method according to any one of Claims 1 to 10, **characterized in that** the controlled change is performed discretely in at least one step from one into another state or continuously, preferably according to a predefined time profile.

**12.** The method according to any one of Claims 1 to 11, **characterized in that** a control magnetic field ($H_s$) is provided overlaid on the tunnel-shaped magnetic field (H).

**13.** The method according to Claim 6, **characterized in that** the surface regions of the target arrangement assigned to the respective electron traps are selected from different materials.

**14.** A method for manufacturing coated substrates, **characterized in that** the distribution of the coating rate and/or the coating material on at least one part of the coating is controlled by controlling a magnetron sputter source according to any one of Claims 1 to 13.

**15.** A magnetron sputter source having a target arrangement (3) having a target sputter surface (1), a magnet arrangement ($9, 9_a, 9_{au}, 9_m, 9_i$) on the target arrangement side facing away from the target sputter surface (1), which magnet arrangement generates, over the target sputter surface (1), at least one closed loop (5) of a tunnel-shaped magnetic field (H) which exits from the target sputter surface (1) and reenters the target sputter surface (1), furthermore an electrode arrangement (11, 11c, 30) operated as an anode with respect to the target arrangement, wherein a controllable magnet arrangement engages on the magnetic field (H) in a changing manner ($\Delta_{SH}$) in a region along the loop, **characterized in that** the controllable magnet arrangement comprises an electromagnet arrangement (19a) and/or a mechanically controlled movable permanent magnet arrangement (19) and/or a mechanically controlled, movable ferromagnetic shunt arrangement (9d), and the magnet arrangement ($9_i, 9_m, 9_a, 9_{au}$), which generates the tunnel-shaped magnetic field (H) exiting from the target sputter surface (1) and reentering the target sputter surface (1), Der Übersetzer hat uns mitgeteilt, dass die beiden Dokumente identisch waren. Einmal in Kasachisch und einmal in Russisch. Wir haben nur einnmal Russisch/Englisch übersetzt. is movable driven with respect to the target arrangement (3), wherein the controlling

electromagnet and/or permanent magnet arrangement and/or shunt arrangement is/are movable together with the electron traps or traps.

**16.** The magnetron sputter source according to Claim 15, **characterized in that** controllable magnet arrangement changes a region ($B_1$) of the loop (5), the length of which is at most 1/3 of the mean circumference of the loop, preferably at most 1/4.

**17.** The magnetron sputter source according to any one of Claims 15 or 16, **characterized in that** the mean spacing (d) of magnetic poles of the magnet arrangement ($9_i, 9_m, 9_a, 9_{au}$) forming the tunnel-shaped magnetic field (H), which generate the tunnel-shaped magnetic field - d - and the length - $l_B$ - of the region, in which the controllable magnet arrangement engages on the loop, behave as follows:

$$0 < l_B \leq 4 \, d,$$

preferably

$$0 < l_B \leq 2 \, d,$$

particularly preferably

$$0 < l_B \leq d.$$

**18.** The magnetron sputter source according to any one of Claims 15 to 17, **characterized in that** the controllable magnet arrangement (19) locally engages in the tunnel-shaped magnetic field and comprises at least one Helmholtz coil arrangement (38).

**19.** The magnetron sputter source according to any one of Claims 15 to 18, **characterized in that** the controllable magnet arrangement (19) locally engages in the tunnel-shaped magnetic field and comprises at least one magnetic cylinder (19) mounted so it is driven to be rotationally movable.

**20.** The magnetron sputter source according to Claim 19, **characterized in that** a drive device for the magnetic cylinder (19) comprises a coil arrangement (21), the field ($H_A$) of which acts on a magnetic dipole (Ds) of the magnetic cylinder (19).

**21.** The magnetron sputter source according to any one of Claims 15 to 20, **characterized in that** more than one of the magnet arrangements ($9_i, 9_m, 9_a, 9_{au}$) forming the tunnel-shaped magnetic field are provided, which each generate a tunnel-shaped magnetic field ($H_a, H_i$) exiting from the target sputter surface (1) and reentering the target sputter surface (1).

**22.** The magnetron sputter source according to Claim 21, **characterized in that** the controllable magnet arrangement (19), which locally engages in the tunnel-shaped magnetic field, acts at least on one of the tunnel-shaped magnetic fields ($H_a$, $H_i$), which are generated by the magnet arrangements, exiting from the target sputter surface and reentering the target sputter surface.

**23.** The magnetron sputter source according to Claim 21 or 22, **characterized in that** the target sputter surfaces, by each of which a tunnel-shaped magnetic field ($H_a$, $H_i$) exiting from the target sputter surface (1) and reentering the target sputter surface (1) is generated, consist of different materials in the region of the mentioned magnetic fields ($H_a$, Hi).

**24.** A sputter coating chamber having a magnetron sputter source according to any one of Claims 15 to 23.

**25.** A vacuum treatment facility having at least one sputter coating chamber according to Claim 24.

**Revendications**

**1.** Procédé pour réguler la répartition de la densité plasmatique sur une disposition cible (3) d'une source de pulvérisation au magnétron, dans lequel il est produit sur une surface de pulvérisation cible (1) de la disposition cible (3) au moins un piège d'électrons comprenant un champ magnétique (H) formé par un dispositif magnétique ($9_i$, $9_m$, $9_a$, $9_{au}$) et qui forme, dans une vue en plan sur la disposition cible (3), une boucle (5) circulaire fermée sur elle-même et, vu dans le sens de la section transversale de la disposition cible, est en forme de tunnel et dans lequel, compte tenu de la boucle (5) du champ magnétique (H) en forme de tunnel et d'un champ électrique (E) coudé en conséquence, qui est réalisé en tant que cathode entre une anode et la disposition cible (3), il est formé un courant d'électrons ($I_e$) qui forme le long et dans la boucle (5) une boucle de courant et ainsi un endroit de densité plasmatique accrue, **caractérisé en ce que**, le long de la boucle (5) du champ magnétique (H) circulaire en forme de tunnel, on modifie de façon contrôlée ce champ magnétique (H) en forme de tunnel dans une zone (B1) de la boucle (5) ($\pm\Delta sH$), dans lequel on déplace le au moins un piège d'électrons au-dessus de la surface de pulvérisation cible (1) à l'aide du dispositif magnétique ($9_i$, $9_m$, $9_a$, $9_{au}$) formant le champ magnétique (H) en forme de tunnel, et **en ce que** l'on effectue la modification contrôlée à l'aide d'un dispositif d'électro-aimants (19a, 38) et/ou d'un dispositif d'aimants permanents (19) déplacés mécaniquement de façon contrôlée et/ou à l'aide d'un shunt ferromagnétique (9d) déplacé mécaniquement de façon contrôlée, le dispositif d'électroaimants et/ou d'aimants permanents et/ou le dispositif de shunt de commande étant déplacé avec le ou les pièges d'électrons.

**2.** Procédé selon la revendication 1, **caractérisé en ce que** l'on modifie le champ magnétique (H) en forme de tunnel à l'intérieur d'une zone ($B_1$) de la boucle (5), la longueur ($l_B$) de cette dernière étant égale au maximum à 1/3 de la longueur circonférentielle médiane (U) de la boucle (5), de préférence au maximum à 1/4.

**3.** Procédé selon l'une des revendications 1 ou 2, **caractérisé en ce que** le dispositif magnétique ($9_i$, $9_m$, $9_a$, $9_{au}$) formant le champ magnétique (H) en forme de tunnel présente des zones polaires, au niveau desquelles le champ magnétique (H) en forme de tunnel sort de la disposition cible et y rentre de nouveau, et **en ce que** l'on procède, à une distance polaire moyenne (d) des zones polaires, à la modification contrôlée sur une longueur de la boucle $l_B$, pour laquelle on applique :

$$0 < l_B \leq 4d$$

de préférence

$$0 < l_B \leq 2\,d$$

de façon particulièrement préférée on applique :

$$0 < l_B \leq d$$

**4.** Procédé selon l'une des revendications 1 à 3, **caractérisé en ce que** l'on contrôle la proportion avec laquelle l'anode intervient dans le champ magnétique (H) en forme de tunnel par une modification locale.

**5.** Procédé selon l'une des revendications 1 à 4, **caractérisé en ce que** l'on modifie le champ magnétique (H) en forme de tunnel en intervenant localement et de façon contrôlée sur le générateur ($9_a$) de ce dernier.

**6.** Procédé selon l'une des revendications 1 à 5, dans lequel au-dessus de la disposition cible (3) il est produit au moins deux pièges d'électrons, **caractérisé en ce que** la modification contrôlée est réalisée au niveau d'au moins l'un des pièges d'électrons, et **en ce que** le rapport de densité plasmatique est ainsi modifié de façon contrôlée entre les pièges d'électrons.

7. Procédé selon la revendication 6, **caractérisé en ce que** le piège d'électrons est réalisé à l'intérieur de l'autre.

8. Procédé selon la revendication 6, **caractérisé en ce que** les deux pièges d'électrons sont réalisés l'un à côté de l'autre.

9. Procédé selon l'une des revendications 1 à 8, **caractérisé en ce qu'**au moins un piège d'électrons est déplacé cycliquement au-dessus de la surface de pulvérisation cible.

10. Procédé selon l'une des revendications 1 à 8, **caractérisé en ce que**, avec la modification contrôlée, on modifie de façon contrôlée la forme de la boucle du piège d'électrons, ou **en ce qu'**on affaiblit ou renforce de façon contrôlée le piège d'électrons jusqu'à son extinction et activation.

11. Procédé selon l'une des revendications 1 à 10, **caractérisé en ce que** l'on procède à la modification contrôlée discrètement en au moins une étape d'un état à l'autre, ou bien de façon continue, de préférence suivant un profil temporel prédéterminé.

12. Procédé selon l'une des revendications 1 à 11, **caractérisé en ce que** l'on prévoit un champ magnétique de commande ($H_s$) superposé au champ magnétique (H) en forme de tunnel.

13. Procédé selon la revendication 6, **caractérisé en ce que** l'on choisit les parties de surface de la disposition cible associées à chacun des pièges d'électrons à partir de différents matériaux.

14. Procédé pour fabriquer des substrats revêtus, **caractérisé en ce que** l'on contrôle la répartition de la vitesse de revêtement et/ou du matériau de revêtement au moins au niveau d'une partie du revêtement en contrôlant une source de pulvérisation au magnétron selon l'une des revendications 1 à 13.

15. Source de pulvérisation au magnétron comprenant une disposition cible (3) avec une surface de pulvérisation cible (1), un dispositif magnétique (9, $9_a$, $9_{au}$, $9_m$, $9_i$) sur le côté de la disposition cible opposé de la surface de pulvérisation cible (1), lequel dispositif magnétique produit sur la surface de pulvérisation cible (1) au moins une boucle (5) fermée sur elle-même d'un champ magnétique (H) en forme de tunnel sortant de la surface de pulvérisation cible (1) et rentrant de nouveau dans la surface de pulvérisation cible (1), comprenant en outre un dispositif d'électrodes (11, 11c, 30) entraîné de façon anodique par rapport à la disposition cible, un dispositif magnétique contrôlable intervenant en modifiant ($\Delta_{SH}$) sur le champ magnétique dans une zone le long de la boucle, **caractérisée en ce que** le dispositif magnétique contrôlable comprend un dispositif d'électroaimants (19a) et/ou un dispositif d'aimants permanents (19) mobiles à contrôle mécanique et/ou un dispositif de shunt ferromagnétique (9d) mobile à contrôle mécanique, et **en ce que** le dispositif magnétique ($9_i$, $9_m$, $9_a$, $9_{au}$) qui produit le champ magnétique (H) en forme de tunnel qui sort de la surface de pulvérisation cible (1) et re-rentre dans la surface de pulvérisation cible (1), peut être déplacé par rapport à la disposition cible (3), le dispositif d'électroaimants et/ou d'aimants permanents de contrôle et/ou le dispositif de shunt pouvant être déplacé(s) avec le ou les pièges d'électrons.

16. Source de pulvérisation au magnétron selon la revendication 15, **caractérisée en ce que** le dispositif magnétique contrôlable est modifié dans une zone ($B_1$) de la boucle (5), la longueur de cette dernière étant au maximum de 1/3 de la circonférence médiane de la boucle, de préférence au maximum de 1/4.

17. Source de pulvérisation au magnétron selon l'une des revendications 15 ou 16, **caractérisée en ce que** la distance moyenne (d) des pôles magnétiques du dispositif magnétique ($9_i$, $9_m$, $9_a$, $9_{au}$) formant le champ magnétique (H) en forme de tunnel qui produisent le champ magnétique en forme de tunnel - d - et la longueur -$l_B$- de la zone, dans laquelle le dispositif magnétique contrôlable intervient dans la boucle, sont déterminées comme suit :

$$0 < l_B \leq 4d$$

de préférence

$$0 < l_B \leq 2d$$

de façon particulièrement préférée

$$0 < l_B \leq d$$

18. Source de pulvérisation au magnétron selon l'une des revendications 15 à 17, **caractérisée en ce que** le dispositif magnétique contrôlable (19) intervient localement dans le champ magnétique en forme de tunnel et comprend au moins une bobine de Helmholtz (38).

19. Source de pulvérisation au magnétron selon l'une des revendications 15 à 18, **caractérisée en ce que** le dispositif magnétique contrôlable (19) intervient localement dans le champ magnétique en forme de tunnel et comprend au moins un cylindre magnétique (19) monté mobile en rotation.

20. Source de pulvérisation au magnétron selon la revendication 19, **caractérisée en ce qu'**un dispositif d'entraînement pour le cylindre magnétique (19) comprend un dispositif de bobine (21) dont le champ ($H_A$) agit sur un dipôle magnétique (Ds) du cylindre magnétique (19).

21. Source de pulvérisation au magnétron selon l'une des revendications 15 à 20, **caractérisée en ce qu'**il est prévu plusieurs dispositifs magnétiques ($9_i$, $9_m$, $9_a$, $9_{au}$) formant le champ magnétique en forme de tunnel, lesquels dispositifs magnétiques produisent chacun un champ magnétique ($H_a$, $H_i$) en forme de tunnel sortant de la surface de pulvérisation cible (1) entrant de nouveau dans la surface de pulvérisation cible (1).

22. Source de pulvérisation au magnétron selon la revendication 21, **caractérisée en ce que** le dispositif magnétique contrôlable (19), qui intervient localement dans le champ magnétique en forme de tunnel, agit au moins sur l'un des champs magnétiques ($H_i$, $H_a$) sortant de la surface de pulvérisation cible et entrant de nouveau dans la surface de pulvérisation cible en forme de tunnel produits par les dispositifs magnétiques.

23. Source de pulvérisation au magnétron selon la revendication 21 ou 22, **caractérisée en ce que** les surfaces de pulvérisation cibles, par lesquelles est produit chaque champ magnétique ($H_a$, $H_i$) en forme de tunnel sortant de la surface de pulvérisation cible (1) et entrant de nouveau dans la surface de pulvérisation cible (1), sont composées dans la zone des champs magnétiques mentionnés ($H_i$, $H_a$) de différents matériaux.

24. Chambre de revêtement par pulvérisation comprenant une source de pulvérisation au magnétron selon l'une des revendications 15 à 23.

25. Installation de traitement sous vide comprenant au moins une chambre de revêtement par pulvérisation selon la revendication 24.

FIG.1

FIG.2

FIG.3

FIG.4

FIG.5

FIG.6

FIG.7

FIG.8

FIG.9

FIG.10

(a)

(b)

FIG.11

EP 1 258 026 B1

(b)

(a)

FIG.12

FIG. 13

FIG. 14

FIG. 15

FIG. 16

FIG.17

FIG.18

FIG.19

FIG.20

(a)

(b)

FIG.21

FIG. 22

FIG. 23 a

FIG. 23b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19749690 A1
- US 5130005 A

- US 5512150 A